(19) Europäisches Patentamt
European Patent Office
Office européen des brevets

(11) **EP 3 747 974 A1**

(12) **EUROPEAN PATENT APPLICATION**
published in accordance with Art. 153(4) EPC

(43) Date of publication:
**09.12.2020 Bulletin 2020/50**

(21) Application number: **18903827.6**

(22) Date of filing: **20.12.2018**

(51) Int Cl.:
***C09K 11/66*** *(2006.01)* ***H01L 33/50*** *(2010.01)*

(86) International application number:
**PCT/JP2018/047003**

(87) International publication number:
**WO 2019/150824 (08.08.2019 Gazette 2019/32)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **30.01.2018 JP 2018013300**

(71) Applicant: **SUMITOMO CHEMICAL COMPANY LIMITED**
**Chuo-ku**
**Tokyo 104-8260 (JP)**

(72) Inventors:
- **NAITO, Shota**
  **Tsukuba-shi, Ibaraki 300-3294 (JP)**
- **MASE, Kentaro**
  **Osaka-shi, Osaka 554-8558 (JP)**

(74) Representative: **J A Kemp LLP**
**14 South Square**
**Gray's Inn**
**London WC1R 5JJ (GB)**

(54) **COMPOSITION, FILM, LAMINATE STRUCTURE, LIGHT-EMITTING DEVICE, AND DISPLAY**

(57) To provide a composition having high thermal durability comprising a perovskite compound.

A composition comprising a component (1), a component (2), and a component (3) described below:
(Composition (1):
A indicates a component positioned at each vertex of a hexahedron having B at the center in a perovskite type crystal structure and is a monovalent cation.
B indicates a component positioned at the centers of the hexahedron where A is disposed at each vertex and the octahedron where X is disposed at each vertex in the perovskite type crystal structure and is a metal ion.
X indicates a component positioned at each vertex of an octahedron having B at the center in the perovskite type crystal structure and is at least one ion selected from the group consisting of a halide ion and a thiocyanate ion.)

Component (2): a compound represented by the formula (C) or a modified product thereof
Component (3): a compound represented by the formula (X1) or the like

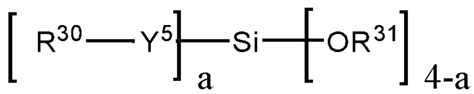

(C)

EP 3 747 974 A1

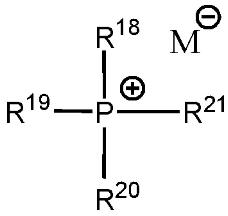

(X1).

## Description

Technical Field

The present invention relates to a composition, a film, a laminate structure, a light emitting device, and a display.

Background Art

An LED backlight having a blue LED (light emitting diode) and a composition having luminescence has been developed. In recent years, perovskite compounds have attracting attention as a compound having luminescence contained in the composition (Non-Patent Document 1).

[Prior Art Document]

[Non-Patent Document]

[Non-Patent Document 1]
L. Protesescu, S. Yakunin, M.I. Bodnarchuk, F. Krieg, R. Caputo, C.H. Hendon, R.X. Yang, A. Walsh, and M.V. Kovalenko, Nano Letters, 15, p. 3692-3696 (2015)

Summary of the Invention

Problems to be Solved by the Invention

However, when a composition containing a perovskite compound as described in above-mentioned Non-Patent Document 1 is used as a light emitting material, further improvement in thermal durability is required.
The present invention has been made in view of the above-mentioned problem, and has an object of providing a composition having high thermal durability containing a perovskite compound.

Means for Solving the Problem

In order to solve the above problem, the present inventors have intensively studied, and resultantly reached the following present invention.
That is, the present invention includes the following [1] to [5].

[1] A composition comprising a component (1), a component (2), and a component (3) described below:

(Composition (1):

A indicates a component positioned at each vertex of a hexahedron having B at the center in a perovskite type crystal structure and is a monovalent cation.
B indicates a component positioned at the centers of the hexahedron where A is disposed at each vertex and the octahedron where X is disposed at each vertex in the perovskite type crystal structure and is a metal ion.
X indicates a component positioned at each vertex of an octahedron having B at the center in the perovskite type crystal structure and is at least one ion selected from the group consisting of a halide ion and a thiocyanate ion.)

Component (2): a compound represented by the formula (C) or a modified product thereof
Component (3): at least one compound selected from the group consisting of compounds represented by the formulae (X1) to (X3) and salts thereof

[Chemical Formula 1]

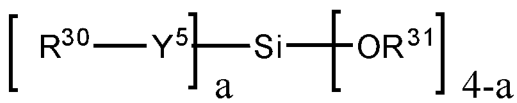

(C)

(In the formula (C), $Y^5$ represents a single bond, an oxygen atom or a sulfur atom.
When $Y^5$ is an oxygen atom, $R^{30}$ and $R^{31}$ each independently represent a hydrogen atom, an alkyl group having 1 to 20 carbon atoms, a cycloalkyl group having 3 to 30 carbon atoms, or an unsaturated hydrocarbon group having 2 to 20 carbon atoms.
When $Y^5$ is a single bond or a sulfur atom, $R^{30}$ represents an alkyl group having 1 to 20 carbon atoms, a cycloalkyl group having 3 to 30 carbon atoms, or an unsaturated hydrocarbon group having 2 to 20 carbon atoms, and $R^{31}$ represents a hydrogen atom, an alkyl group having 1 to 20 carbon atoms, a cycloalkyl group having 3 to 30 carbon atoms, or an unsaturated hydrocarbon group having 2 to 20 carbon atoms.
Each hydrogen atom contained in the group represented by $R^{30}$ or $R^{31}$ may be independently substituted with a halogen atom.
a is an integer of 1 to 3.
When a is 2 or 3, a plurality of $Y^5$ may be the same or different.
When a is 2 or 3, a plurality of $R^{30}$ may be the same or different.
When a is 1 or 2, a plurality of $R^{31}$ may be the same or different.)

[Chemical Formula 2]

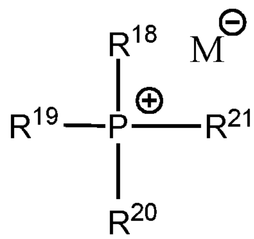

(X1)

[Chemical Formula 3]

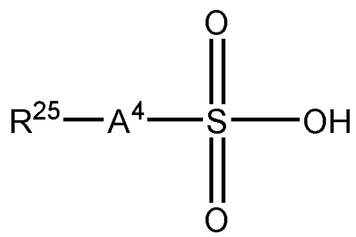

(X2)

[Chemical Formula 4]

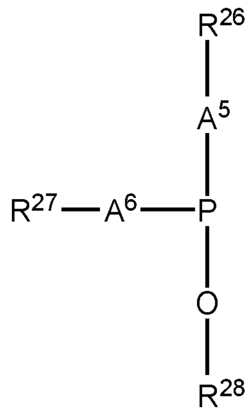

(X3)

(In the formula (X1), $R^{18}$ to $R^{21}$ each independently represent an alkyl group having 1 to 20 carbon atoms, a cycloalkyl group having 3 to 30 carbon atoms, or an aryl group having 6 to 30 carbon atoms, and they optionally have a substituent. $M^-$ represents a counter anion.
In formula (X2), $A^4$ represents a single bond or an oxygen atom. $R^{25}$ represents an alkyl group having 1 to 12 carbon atoms, a cycloalkyl group having 3 to 30 carbon atoms, or an aryl group having 6 to 30 carbon atoms, and they optionally have a substituent.
In formula (X3), $A^5$ and $A^6$ each independently represent a single bond or an oxygen atom. $R^{26}$ to $R^{28}$ each independently represent an alkyl group having 1 to 20 carbon atoms, a cycloalkyl group having 3 to 30 carbon atoms, an aryl group having 6 to 30 carbon atoms, an alkenyl group having 2 to 20 carbon atoms, or an alkynyl group having 2 to 20 carbon atoms, and they optionally have a substituent.
The hydrogen atoms contained in the groups represented by $R^{18}$ to $R^{21}$ and $R^{25}$ to $R^{28}$ may be independently substituted with a halogen atom.).

[2] A film using the composition according to [1].
[3] A laminated structure comprising the film according to [2].
[4] A light emitting device comprising the laminated structure according to [3].
[5] A display comprising the laminated structure according to [3].

Effect of the Invention

According to the present invention, it is possible to provide a composition having high thermal durability, and a film, a laminate structure, a light emitting device, and a display using the composition.

Brief Description of Drawings

FIG. 1 is a sectional view showing an embodiment of a laminated structure according to the present invention.
FIG. 2 is a sectional view showing an embodiment of a display according to the present invention.

Modes For Carrying Out The Invention

<Composition>

The composition of the present invention has luminescence. "Luminescence" refers to the property of emitting light. The composition preferably has a property of emitting light by excitation, and more preferably has a property of emitting light by excitation of excitation light. The wavelength of the excitation light may be, for example, 200 nm to 800 nm, 250 nm to 750 nm, or 300 nm to 700 nm.
The composition of the present invention contains the following components (1), (2) and (3).

(1) Component: a perovskite compound having A, B and X.

(A indicates a component positioned at each vertex of a hexahedron having B at the center in a perovskite type crystal structure and is a monovalent cation.
B indicates a component positioned at the centers of the hexahedron where A is disposed at each vertex and the octahedron where X is disposed at each vertex in the perovskite type crystal structure and is a metal ion.
X indicates a component positioned at each vertex of an octahedron having B at the center in the perovskite type crystal structure and is at least one ion selected from the group consisting of a halide ion and a thiocyanate ion.)

Component (2): a compound represented by the formula (C) or a modified product thereof
Component (3): at least one selected from the group consisting of compounds represented by the formulae (X1) to (X3) and salts thereof

[Chemical Formula 5]

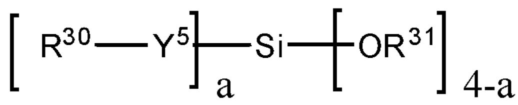

(C)

(In the formula (C), $Y^5$ represents a single bond, an oxygen atom or a sulfur atom.

When $Y^5$ is an oxygen atom, $R^{30}$ and $R^{31}$ each independently represent a hydrogen atom, an alkyl group having 1 to 20 carbon atoms, a cycloalkyl group having 3 to 30 carbon atoms, or an unsaturated hydrocarbon group having 2 to 20 carbon atoms.

When $Y^5$ is a single bond or a sulfur atom, $R^{30}$ represents an alkyl group having 1 to 20 carbon atoms, a cycloalkyl group having 3 to 30 carbon atoms, or an unsaturated hydrocarbon group having 2 to 20 carbon atoms, and $R^{31}$ represents a hydrogen atom, an alkyl group having 1 to 20 carbon atoms, a cycloalkyl group having 3 to 30 carbon atoms, or an unsaturated hydrocarbon group having 2 to 20 carbon atoms.

Each hydrogen atom contained in the group represented by $R^{30}$ or $R^{31}$ may be independently substituted with a halogen atom.

a is an integer of 1 to 3.

When a is 2 or 3, a plurality of $Y^5$ may be the same or different.

When a is 2 or 3, a plurality of $R^{30}$ may be the same or different.

When a is 1 or 2, a plurality of $R^{31}$ may be the same or different.)

[Chemical Formula 6]

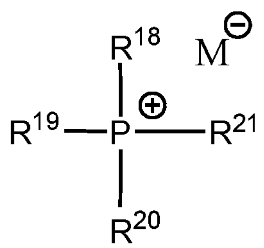

(X1)

[Chemical Formula 7]

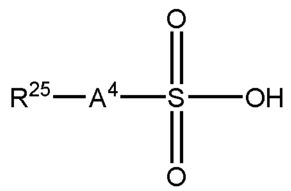

(X2)

[Chemical Formula 8]

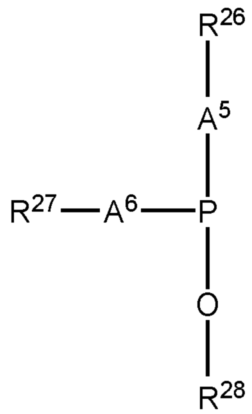

(X3)

(In the formula (X1), $R^{18}$ to $R^{21}$ each independently represent an alkyl group having 1 to 20 carbon atoms, a cycloalkyl group having 3 to 30 carbon atoms, or an aryl group having 6 to 30 carbon atoms, and they optionally have a substituent. $M^-$ represents a counter anion.

In the formula (X2), $A^4$ represents a single bond or an oxygen atom. $R^{25}$ represents an alkyl group having 1 to 12 carbon atoms, a cycloalkyl group having 3 to 30 carbon atoms, or an aryl group having 6 to 30 carbon atoms, and they optionally have a substituent.

In the formula (X3), $A^5$ and $A^6$ each independently represent a single bond or an oxygen atom. $R^{26}$ to $R^{28}$ each independently represent an alkyl group having 1 to 20 carbon atoms, a cycloalkyl group having 3 to 30 carbon atoms, an aryl group having 6 to 30 carbon atoms, an alkenyl group having 2 to 20 carbon atoms, or an alkynyl group having 2 to 20 carbon atoms, and they optionally have a substituent.

The hydrogen atoms contained in the groups represented by $R^{18}$ to $R^{21}$ and $R^{25}$ to $R^{28}$ may be independently substituted with a halogen atom.).

In the composition of the present embodiment, the total content of the component (1), the component (2), and the component (3) with respect to the whole composition is not particularly limited, and may be 95% by mass or more, may be 99% by mass or more, or may be 100% by mass.

The content ratio of the component (1) with respect to the whole composition is usually 0.0001% by mass to 50% by mass, preferably 0.01% by mass to 20% by mass, more preferably 0.1% by mass to 15% by mass or less, and further preferably 1% by mass to 10% by mass or less.

The content ratio of the component (2) with respect to the whole composition is usually 0.01% by mass to 99% by mass, preferably 1% by mass to 96% by mass, more preferably 10% by mass to 95% by mass or less, and further preferably 40% by mass to 94% by mass or less.

The content ratio of the component (3) with respect to the whole composition is usually 0.01% by mass to 70% by mass, preferably 0.1% by mass to 60% by mass, more preferably 0.5% by mass to 55% by mass or less, and further preferably 1% by mass to 53% by mass or less.

A composition in which the respective ranges relating to the blending of the component (1), the component (2), and the component (3) are within the above ranges is preferable in that the component (1) hardly agglomerates and exhibits high luminescence.

The composition of the present embodiment may contain at least one selected from the group consisting of the following components (4) and (5).

(4) Component: a solvent.

(5) Component: a polymerizable compound or a polymer thereof.

In the present embodiment, the component (1) is preferably dispersed in at least one selected from the group consisting of the component (4) and the component (5) .

In the composition of the embodiment containing the component (1), the component (2), and the component (3), and at least one selected from the group consisting of the component (4) and the component (5), the total of a composition containing the component (1), the component (2) and the components (3) and at least one selected from the group consisting of the components (4) and (5) with respect to the whole composition may be 95% by mass or more, may be 99% by mass or more, or may be 100% by mass.

The content ratio of the component (1) with respect to the whole composition is usually 0.0001% by mass to 50% by mass, preferably 0.0001% by mass to 1% by mass, more preferably 0.0005% by mass to 1% by mass or less, further preferably 0.001% to 0.5% by mass or less, and most preferably 0.05% to 0.3% by mass or less.

The content ratio of the component (2) with respect to the whole composition is usually 0.0001% by mass to 50% by mass, preferably 0.0001% by mass to 1% by mass, more preferably 0.05% by mass to 10% by mass or less, and further preferably 1% by mass to 7% by mass or less.

The content ratio of the component (3) with respect to the whole composition is usually 0.0001% by mass to 50% by mass, preferably 0.001% by mass to 10% by mass, more preferably 0.005% by mass to 5% by mass or less, further preferably 0.01% by mass to 3% by mass or less.

The content ratio of at least one selected from the group consisting of the component (4) and the component (5) with respect to the whole composition is usually 0.0001% by mass to 99% by mass, preferably 10% by mass to 99% by mass, more preferably 30% by mass to 98.5% by mass or less, and further preferably 70% by mass to 98% by mass or less.

The above upper limits and lower limits can be arbitrarily combined.

A compositions in which the respective ranges relating to the blending of the component (1), the component (2), and the component (3) and at least one type selected from the group consisting of the components (4) and (5) are within the above ranges is preferable in that the component (1) hardly agglomerates and exhibits high luminescence.

It is preferable that the composition of the present embodiment includes the component (1), the component (2), the component (3), and the following component (5'), and the total amount of the components (1), (2), (3), and the components (5 ') is 90% by mass or more with respect to the whole composition. Component (5'): a polymer

In the composition of the present embodiment, the component (1) is preferably dispersed in the component (5').

In the composition of the present embodiment, the total of the component (1), the component (2), the component (3), and the component (5') may be 95% by mass or more, may be 99% by mass or more, and may be 100% by mass with respect to the whole composition.

The content ratio of the component (1) with respect to the whole composition is usually 0.0001% by mass to 50% by mass, preferably 0.0001% by mass to 1% by mass, more preferably 0.0005% by mass to 1% by mass or less, further preferably 0.001% by mass to 0.5% by mass or less, and most preferably 0.05% by mass to 0.3% by mass or less.

The content ratio of the component (2) with respect to the whole composition is usually 0.0001% by mass to 50% by mass, preferably 0.0001% by mass to 1% by mass, more preferably 0.05% by mass to 10% by mass or less, and further preferably 1% by mass to 7% by mass or less.

The content ratio of the component (3) with respect to the whole composition is usually 0.0001% by mass to 50% by mass, preferably 0.001% by mass to 10% by mass, more preferably 0.005% by mass to 5% by mass or less, and further preferably 0.01% by mass to 3% by mass or less.

The content ratio of the component (5') with respect to the whole composition is usually 0.0001% by mass to 99% by mass, preferably 10% by mass to 99% by mass, more preferably 30% by mass to 98.5% by mass or less, and further preferably 70% by mass to 98% by mass or less.

The above upper limits and lower limits can be arbitrarily combined.

A composition in which the respective ranges relating to the blending of the component (1), the component (2), the component (3), and the component (5') are within the above ranges is preferable in that the component (1) hardly agglomerates and exhibits high luminescence.

The composition of the present embodiment may contain the following component (6). (6) Component: at least one selected from the group consisting of ammonia, amine, and carboxylic acid, and salts or ions thereof.

In the composition of the present embodiment, the total of the component (1), the component (2), the component (3), and the component (6) may be 0.1% by mass or more, may be 99% by mass or more, and may be 100% by mass with respect to the whole composition.

The content ratio of the component (1) with respect to the whole composition is usually 0.0001% by mass to 50% by mass, preferably 0.01% by mass to 20% by mass, more preferably 0.1% by mass to 15% by mass or less, further preferably 1% by mass to 10% by mass or less.

The content ratio of the component (2) with respect to the whole composition is usually 0.01% by mass to 99% by mass, preferably 1% by mass to 96% by mass, more preferably 10% by mass to 95% by mass or less, and further preferably 40% by mass to 94% by mass or less.

The content ratio of the component (3) with respect to the whole composition is usually 0.01% by mass to 70% by mass, preferably 0.1% by mass to 60% by mass, more preferably 0.5% by mass to 55% by mass or less, and further preferably 1% by mass to 53% by mass or less.

The content ratio of the component (6) with respect to the whole composition is usually 0.0001% by mass to 50% by mass, preferably 0.0001% by mass to 20% by mass, more preferably 0.01% by mass to 10% by mass or less, and further preferably 0.1% by mass to 5% by mass or less.

The above upper limits and lower limits can be arbitrarily combined.

A composition in which the respective ranges relating to the blending of the component (1), the component (2), the component (3), and the component (6) are within the above ranges is preferable in that the component (1) hardly agglomerates and exhibits high luminescence.

The composition of the present embodiment may contain other components other than the components (1) to (6) described above.

Other components include, for example, some impurities, a compound having an amorphous structure composed of elemental components constituting the perovskite compound, and a polymerization initiator.

Other components are preferably 10% by mass or less, more preferably 5% by mass or less, and further preferably 1% by mass or less with respect to the whole composition.

Hereinafter, embodiments of the composition of the present invention will be described.

<<(1) Component>>

The component (1) is a perovskite compound having A, B, and X. Hereinafter, the component (1) will be described.

The perovskite compound contained in the composition of the present embodiment is a perovskite compound having A, B, and X.

(A indicates a component positioned at each vertex of a hexahedron having B at the center in a perovskite type crystal structure and is a monovalent cation.

X indicates a component positioned at each vertex of an octahedron having B at the center in the perovskite type crystal structure and is at least one ion selected from the group consisting of a halide ion and a thiocyanate ion.

B indicates a component positioned at the centers of the hexahedron where A is disposed at each vertex and the octahedron where X is disposed at each vertex in the perovskite type crystal structure and is a metal ion.) .

The perovskite compound having A, B, and X is not particularly limited, and may be a compound having any of a three-dimensional structure, a two-dimensional structure, and a pseudo two-dimensional structure. In the case of a three-dimensional structure, the perovskite compound is represented by $ABX_{(3+\delta)}$. In the case of a two-dimensional structure, the perovskite compound is represented by $A_2BX_{(4+\delta)}$. Here, $\delta$ is a number that can be appropriately changed according to the charge balance of B, and is -0.7 or more and 0.7 or less.

The perovskite compound is preferably a perovskite compound represented by the following general formula (1) .

$$ABX_{(3+\delta)} \quad (-0.7 \leq \delta \leq 0.7) \quad (1)$$

[In the general formula (1), A is a monovalent cation, B is a metal ion, X is at least one ion selected from the group consisting of a halide ion and a thiocyanate ion.]

[A]

In the perovskite compound, A indicates a component positioned at each vertex of a hexahedron having B at the center in the above-described perovskite type crystal structure and is a monovalent cation. The monovalent cation includes a cesium ion, an organic ammonium ion, or an amidinium ion. In the perovskite compound, when A is a cesium

ion, an organic ammonium ion having 3 or less carbon atoms, or an amidinium ion having 3 or less carbon atoms, the perovskite compound has generally a three-dimensional structure represented by $ABX_{(3+\delta)}$.

A in the perovskite compound is preferably a cesium ion or an organic ammonium ion.

Specific examples of the organic ammonium ion of A include cations represented by the following general formula (A3).

[Chemical Formula 9]

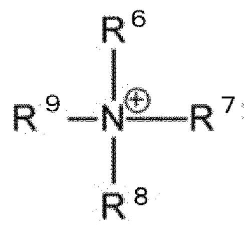

(A3)

In the general formula (A3), $R^6$ to $R^9$ each independently represent a hydrogen atom, an alkyl group optionally having an amino group as a substituent, or a cycloalkyl group optionally having an amino group as a substituent.

The alkyl group represented by $R^6$ to $R^9$ may be linear or branched, and may have an amino group as a substituent.

The number of carbon atoms of the alkyl group represented by $R^6$ to $R^9$ is usually 1 to 20, preferably 1 to 4, and more preferably 1 to 3.

The cycloalkyl group represented by $R^6$ to $R^9$ may have an alkyl group as a substituent or may have an amino group.

The number of carbon atoms of the cycloalkyl group represented by $R^6$ to $R^9$ is usually 3 to 30, preferably 3 to 11, and more preferably 3 to 8. The number of carbon atoms includes also the number of carbon atoms in the substituent.

Each of $R^6$ to $R^9$ is preferably independently a hydrogen atom or an alkyl group.

By reducing the number of alkyl groups and cycloalkyl groups that can be included in the general formula (A3), and reducing the number of carbon atoms of the alkyl groups and cycloalkyl groups, a compound having a perovskite type crystal structure having a three-dimensional structure with high emission intensity can be obtained.

When the number of carbon atoms of the alkyl group or the cycloalkyl group is 4 or more, a compound having a two-dimensional and/or pseudo two-dimensional (quasi-2D) perovskite type crystal structure in part or in whole can be obtained. When a two-dimensional perovskite type crystal structure is stacked infinitely, it becomes equivalent to a three-dimensional perovskite type crystal structure (Reference: PP Boix et al., J. Phys. Chem. Lett. 2015, 6, 898-907. etc.).

The total number of carbon atoms contained in the alkyl group and the cycloalkyl group represented by $R^6$ to $R^9$ is preferably 1 to 4, and it is more preferable that one of $R^6$ to $R^9$ is an alkyl group having 1 to 3 carbon atoms and three of $R^6$ to $R^9$ are hydrogen atoms.

Examples of the alkyl group of $R^6$ to $R^9$ include a methyl group, an ethyl group, an n-propyl group, an isopropyl group, an n-butyl group, an isobutyl group, a sec-butyl group, a tert-butyl group, a n-pentyl group, an isopentyl group, a neopentyl group, a tert-pentyl group, a 1-methylbutyl group, a n-hexyl group, a 2-methylpentyl group, a 3-methylpentyl group, a 2,2-dimethylbutyl group, a 2,3-dimethylbutyl group, a n-heptyl group, a 2-methylhexyl group, a 3-methylhexyl group, a 2,2-dimethylpentyl group, a 2,3-dimethylpentyl group, a 2,4-dimethylpentyl group, a 3,3-dimethylpentyl group, a 3-ethylpentyl group, a 2,2,3-trimethylbutyl group, a n-octyl group, an isooctyl group, a 2-ethylhexyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group, and an eicosyl group.

As the cycloalkyl group of $R^6$ to $F^9$, those in which an alkyl group having 3 or more carbon atoms forms a ring exemplified for the alkyl group of $R^6$ to $R^9$ are mentioned, and exemplified are a cyclopropyl group, a cyclobutyl group, a cyclopentyl group, a cyclohexyl group, a cycloheptyl group, a cyclooctyl group, a cyclononyl group, a cyclodecyl group, a norbornyl group, an isobornyl group, a 1-adamantyl group, a 2-adamantyl group, a tricyclodecyl group and the like.

The organic ammonium ion represented by A is preferably $CH_3NH_3^+$ (methyl ammonium ion), $C_2H_5NH_3^+$ (ethyl ammonium ion) or $C_3H_7NH_3^+$ (propyl ammonium ion), more prefreably $CH_3NH_3^+$ or $C_2H_5NH_3^+$, and further preferably $CH_3NH_3^+$.

Examples of the amidinium ion represented by A include amidinium ions represented by the following general

formula (A4).

$$(R^{10}R^{11}N=CH-NR^{12}R^{13})^{+} \qquad (A4)$$

In the general formula (A4), $R^{10}$ to $R^{13}$ each independently represent a hydrogen atom, an alkyl group optionally having an amino group as a substituent, or a cycloalkyl group optionally having an amino group as a substituent.
The alkyl group represented by $R^{10}$ to $R^{13}$ may be linear or branched, and may have an amino group as a substituent.
The number of carbon atoms of the alkyl group represented by $R^{10}$ to $R^{13}$ is usually 1 to 20, preferably 1 to 4, and more preferably 1 to 3.
The cycloalkyl group represented by $R^{10}$ to $R^{13}$ may have an alkyl group or an amino group as a substituent.
The number of carbon atoms of the cycloalkyl group represented by $R^{10}$ to $R^{13}$ is usually 3 to 30, preferably 3 to 11, and more preferably 3 to 8. The number of carbon atoms includes the number of carbon atoms in the substituent.
Specific examples of the alkyl group for $R^{10}$ to $R^{13}$ include the alkyl groups exemplified for $R^6$ to $R^9$.
Specific examples of the cycloalkyl group for $R^{10}$ to $R^{13}$ include the cycloalkyl groups exemplified for $R^6$ to $R^9$.
$R^{10}$ to $R^{13}$ are preferably a hydrogen atom or an alkyl group.
By reducing the number of alkyl groups and cycloalkyl groups contained in the general formula (A4) and reducing the number of carbon atoms of the alkyl groups and cycloalkyl groups, a perovskite compound having a three-dimensional structure with high emission intensity can be obtained.
When the alkyl group or the cycloalkyl group has 4 or more carbon atoms, a compound having a two-dimensional and/or pseudo two-dimensional (quasi-2D) perovskite type crystal structure in part or in whole can be obtained. Further, the total number of carbon atoms contained in the alkyl group and the cycloalkyl group represented by $R^{10}$ to $R^{13}$ is preferably 1 to 4, and it is more preferable that $R^{10}$ is an alkyl group having 1 to 3 carbon atoms and $R^{11}$ to $R^{13}$ are hydrogen atoms.

[B]

In the perovskite compound, B indicates a component positioned at the centers of the hexahedron where A is disposed at each vertex and the octahedron where X is disposed at each vertex in the above-described perovskite type crystal structure and is a metal ion. The metal ion of the component B may be one or more ions selected from the group consisting of monovalent metal ions, divalent metal ions, and trivalent metal ions. B preferably contains a divalent metal ion, and more preferably contains one or more metal ions selected from the group consisting of lead and tin.

[X]

In the perovskite compound, X indicates a component positioned at each vertex of an octahedron having B at the center in the above-described perovskite type crystal structure and is at least one ion selected from the group consisting of a halide ion and a thiocyanate ion. X may be at least one ion selected from the group consisting of chloride ion, bromide ion, fluoride ion, iodide ion, and thiocyanate ion.
X can be appropriately selected according to a desired emission wavelength, and for example, X can include a bromide ion.
When X is two or more halide ions, the content ratio of the halide ions can be appropriately selected according to the emission wavelength, and for example, a combination of a bromide ion and a chloride ion, or a combination of a bromide ion and an iodide can be adopted.
In the present specification, the perovskite structure can be confirmed by an X-ray diffraction pattern.
In the case of the compound having a perovskite type crystal structure having the three-dimensional structure, a peak derived from (hkl) = (001) is usually confirmed at a position of 2θ = 12 to 18°, or a peak derived from (hkl) = (110) is usually confirmed at a position of 2θ = 18 to 25° in an X-ray diffraction pattern. It is more preferable that a peak derived from (hkl) = (001) is confirmed at a position of 2θ = 13 to 16°, and a peak derived from (hkl) = (110) is confirmed at a position of 2θ = 20 to 23°.
In the case of the compound having a two-dimensional perovskite type crystal structure, a peak derived from (hkl) = (002) is usually confirmed at a position of 2θ = 1 to 10° in an X-ray diffraction pattern, and a peak derived from (hkl) = (002) is more preferably confirmed at a position of 2θ = 2 to 8°.
Specific examples of the perovskite compound having a three-dimensional perovskite type crystal structure represented by $ABX_{(3+\delta)}$ include
$CH_3NH_3PbBr_3$, $CH_3NH_3PbCl_3$, $CH_3NH_3PbI_3$, $CH_3NH_3PbBr_{(3-y)}I_y$ ($0<y<3$), $CH_3NH_3PbBr_{(3-y)}Cl_y$ ($0<y<3$), $(H_2N=CH-NH_2)PbBr_3$, $(H_2N=CH-NH_2)PbCl_3$, $(H_2N=CH-NH_2)PbI_3$,
$CH_3NH_3Pb_{(1-a)}Ca_aBr_3$ ($0<a\leq0.7$), $CH_3NH_3Pb_{(1-a)}Sr_aBr_3$ ($0<a\leq0.7$), $CH_3NH_3Pb_{(1-a)}La_aBr_{(3+\delta)}$ ($0<a\leq0.7$, $0<\delta\leq0.7$),

$CH_3NH_3Pb_{(1-a)}Ba_aBr_3$ ($0<a\leq0.7$), $CH_3NH_3Pb_{(1-a)}Dy_aBr_{(3+\delta)}$ ($0<a\leq0.7$, $0<\delta\leq0.7$), $CH_3NH_3Pb_{(1-a)}Na_aBr_{(3+\delta)}$ ($0<a\leq0.7$, $-0.7\leq\delta<0$), $CH_3NH_3Pb_{(1-a)}Li_aBr_{(3+\delta)}$ ($0<a\leq0.7$, $-0.7\leq\delta<0$), $CsPb_{(1-a)}Na_aBr_{(3+\delta)}$ ($0<a\leq0.7$, $-0.7\leq\delta<0$), $CsPb_{(1-a)}Li_aBr_{(3+\delta)}$ ($0<a\leq0.7$, $-0.7\leq\delta<0$), $CH_3NH_3Pb_{(1-a)}Na_aBr_{(3+\delta-y)}I_y$ ($0<a\leq0.7$, $-0.7\leq\delta<0$, $0<y<3$), $CH_3NH_3Pb_{(1-a)}Li_aBr_{(3+\delta-y)}I_y$ ($0<a\leq0.7$, $-0.7\leq\delta<0$, $0<y<3$), $CH_3NH_3Pb_{(1-a)}Na_aBr_{(3+\delta-y)}Cl_y$ ($0<a\leq0.7$, $-0.7\leq\delta<0$, $0<y<3$), $CH_3NH_3Pb_{(1-a)}Li_aBr_{(3+\delta-y)}Cl_y$ ($0<a\leq0.7$, $-0.7\leq\delta<0$, $0<y<3$), $(H_2N{=}CH{-}NH_2)Pb_{(1-a)}Na_aBr_{(3+\delta)}$ ($0<a\leq0.7$, $-0.7\leq-\delta<0$), $(H_2N{=}CH{-}NH_2)Pb_{(1-a)}Li_aBr_{(3+\delta)}$ ($0<a\leq0.7$, $-0.7\leq\delta<0$), $(H_2N{=}CH{-}NH_2)Pb_{(1-a)}Na_aBr_{(3+\delta-y)}I_y$ ($0<a\leq0.7$, $-0.7\leq\delta<0$, $0<y<3$), $(H_2N{=}CH{-}NH_2)Pb_{(1-a)}Na_aBr_{(3+\delta-y)}Cl_y$ ($0<a\leq0.7$,$-0.7\leq\delta<0$, $0<y<3$), $CsPbBr_3$, $CsPbCl_3$, $CsPbI_3$, $CsPbBr_{(3-y)}I_y$ ($0<y<3$), $CsPbBr_{(3-y)}Cl_y$ ($0<y<3$), $CH_3NH_3PbBr_{(3-y)}Cl_y$ ($0<y<3$), $CH_3NH_3Pb_{(1-a)}Zn_aBr_3$ ($0<a\leq0.7$), $CH_3NH_3Pb_{(1-a)}Al_aBr_{(3+\delta)}$ ($0<a\leq0.7$, $0\leq\delta\leq0.7$), $CH_3NH_3Pb_{(1-a)}Co_aBr_3$ ($0<a\leq0.7$), $CH_3NH_3Pb_{(1-a)}Mn_aBr_3$ ($0<a\leq0.7$), $CH_3NH_3Pb_{(1-a)}Mg_aBr_3$ ($0<a\leq0.7$), $CsPb_{(1-a)}Zn_aBr_3$ ($0<a\leq0.7$), $CsPb_{(1-a)}Al_aBr_{(3+\delta)}$ ($0<a\leq0.7$, $0<\delta\leq0.7$), $CsPb_{(1-a)}Co_aBr_3$ ($0<a\leq0.7$), $CsPb_{(1-a)}Mn_aBr_3$ ($0<a\leq0.7$), $CsPb_{(1-a)}Mg_aBr_3$ ($0<a\leq0.7$), $CH_3NH_3Pb_{(1-a)}Zn_aBr_{(3-y)}I_y$ ($0<a\leq0.7$, $0<y<3$), $CH_3NH_3Pb_{(1-a)}Al_aBr_{(3+\delta-y)}I_y$ ($0<a\leq0.7$, $0<\delta\leq0.7$, $0<y<3$), $CH_3NH_3Pb_{(1-a)}Co_aBr_{(3-y)}I_y$ ($0<a\leq0.7$, $0<y<3$), $CH_3NH_3Pb_{(1-a)}Mn_aBr_{(3-y)}I_y$ ($0<a\leq0.7$, $0<y<3$), $CH_3NH_3Pb_{(1-a)}Mg_aBr_{(3-y)}I_y$ ($0<a\leq0.7$, $0<y<3$), $CH_3NH_3Pb_{(1-a)}Zn_aBr_{(3-y)}Cl_y$ ($0<a\leq0.7$, $0<y<3$), $CH_3NH_3Pb_{(1-a)}Al_aBr_{(3+\delta-y)}Cl_y$ ($0<a\leq0.7$, $0<\delta\leq0.7$, $0<y<3$), $CH_3NH_3Pb_{(1-a)}Co_aBr_{(3+\delta-y)}Cl_y$ ($0<a\leq0.7$, $0<y<3$), $CH_3NH_3Pb_{(1-a)}Mn_aBr_{(3-y)}Cl_y$ ($0<a\leq0.7$, $0<y<3$), $CH_3NH_3Pb_{(1-a)}Mg_aBr_{(3-y)}Cl_y$ ($0<a\leq0.7$, $0<y<3$), $(H_2N{=}CH{-}NH_2)$ZnaBr3) ($0<a\leq0.7$), $(H_2N{=}CH{-}NH_2)$MgaBr3 ($0<a\leq0.7$), $(H_2N{=}CH{-}NH_2)Pb_{(1-a)}Zn_aBr_{(3-y)}I_y$ ($0<a\leq0.7$, $0<y<3$), $(H_2N{=}CH{-}NH_2)Pb_{(1-a)}Zn_aBr_{(3-y)}Cl_y$ ($0<a\leq0$, $0<y<3$), and the like, as preferable examples.

Specific examples of the perovskite compounds having a two-dimensional perovskite type crystal structure represented by $A_2BX_{(4+\delta)}$ include:

$(C_4H_9NH_3)_2PbBr_4$, $(C_4H_9NH_3)_2PbCl_4$, $(C_4H_9NH_3)_2PbI_4$, $(C_7H_{15}NH_3)_2PbBr_4$, $(C_7H_{15}NH_3)_2PbCl_4$, $(C_7H_{15}NH_3)_2PbI_4$, $(C_4H_9NH_3)_2Pb_{(1-a)}Li_aBr_{(4+\delta)}$ ($0<a\leq0.7$, $-0.7\leq\delta<0$), $(C_4H_9NH_3)_2Pb_{(1-a)}Na_aBr_{(4+\delta)}$ ($0<a\leq0.7$, $-0.7\leq\delta<0$), $(C_4H_9NH_3)_2Pb_{(1-a)}Rb_aBr_{(4+\delta)}$ ($0<a\leq0.7$, $-0.7\leq\delta<0$), $(C_7H_{15}NH_3)_2Pb_{(1-a)}Na_aBr_{(4+\delta)}$ ($0<a\leq0.7$, $-0.7\leq\delta<0$), $(C_7H_{15}NH_3)_2Pb_{(1-a)}Li_aBr_{(4+\delta)}$ ($0<a\leq0.7$, $-0.7\leq\delta<0$), $(C_7H_{15}NH_3)_2Pb_{(1-a)}Rb_aBr_{(4+\delta)}$ ($0<a\leq0.7$, $-0.7\leq\delta<0$), $(C_4H_9NH_3)_2Pb_{(1-a)}Na_aBr_{(4+\delta-y)}I_y$ ($0<a\leq0.7$, $-0.7\leq\delta<0$, $0<y<4$), $(C_4H_9NH_3)_2Pb_{(1-a)}Li_aBr_{(4+\delta-y)}I_y$ ($0<a\leq0.7$, $-0.7\leq\delta<0$, $0<y<4$), $(C_4H_9NH_3)_2Pb_{(1-a)}Rb_aBr_{(4+\delta-y)}I_y$ ($0<a\leq0.7$, $-0.7\leq\delta<0$, $0<y<4$), $(C_4H_9NH_3)_2Pb_{(1-a)}Na_aBr_{(4+\delta-y)}Cl_y$ ($0<a\leq0.7$, $-0.7\leq\delta<0$, $0<y<4$), $(C_4H_9NH_3)_2Pb_{(1-a)}Li_aBr_{(4+\delta-y)}Cl_y$ ($0<a\leq0.7$, $-0.7\leq\delta<0$, $0<y<4$), $(C_4H_9NH_3)_2Pb_{(1-a)}Rb_aBr_{(4+\delta-y})Cl_y$ ($0<a\leq0.7$, $-0.7\leq5<0$, $0<y<4$), $(C_4H_9NH_3)_2PbBr_4$, $(C_7H_{15}NH_3)_2PbBr_4$, $(C_4H_9NH_3)_2PbBr_{(4-y)}Cl_y$ ($0<y<4$), $(C_4H_9NH_3)_2PbBr_{(4-y)}I_y$ ($0<y<4$), $(C_4H_9NH_3)_2Pb_{(1-a)}Zn_aBr_4$ ($0<a\leq0.7$), $(C_4H_9NH_3)_2Pb_{(1-a)}Mg_aBr_4$ ($0<a\leq0.7$), $(C_4H_9NH_3)_2Pb_{(1-a)}Co_aBr_4$ ($0<a\leq0.7$), $(C_4H_9NH_3)_2Pb_{(1-a)}Mn_aBr_4$ ($0<a\leq0.7$), $(C_7H_{15}NH_3)_2Pb_{(1-a)}Zn_aBr_4$ ($0<a\leq0.7$), $(C_7H_{15}NH_3)_2Pb_{(1-a)}Mg_aBr_4$ ($0<a\leq0.7$), $(C_7H_{15}NH_3)_2Pb_{(1-a)}Co_aBr_4$ ($0<a\leq0.7$), $(C_7H_{15}NH_3)_2Pb_{(1-a)}Mn_aBr_4$ ($0<a\leq0.7$), $(C_4H_9NH_3)_2Pb_{(1-a)}Zn_aBr_{(4-y)}I_y$ ($0<a\leq0.7$, $0<y<4$), $(C_4H_9NH_3)_2Pb_{(1-a)}Mg_aBr_{(4-y)}I_y$ ($0<a\leq0.7$, $0<y<4$), $(C_4H_9NH_3)_2Pb_{(1-a)}Co_aBr_{(4-y)}I_y$ ($0<a\leq0.7$, $0<y<4$), $(C_4H_9NH_3)_2Pb_{(1-a)}Mn_aBr_{(4-y)}I_y$ ($0<a\leq0.7$, $0<y<4$), $(C_4H_9NH_3)_2Pb_{(1-a)}Zn_aBr_{(4-y)}Cl_y$ ($0<a\leq0.7$, $0<y<4$), $(C_4H_9NH_3)_2Pb_{(1-a)}Mg_aBr_{(4-y)}Cl_y$ ($0<a\leq0.7$, $0<y<4$), $(C_4H_9NH_3)_2Pb_{(1-a)}Co_aBr_{(4-y)}Cl_y$ ($0<a\leq0.7$, $0<y<4$), $(C_4H_9NH_3)_2Pb_{(1-a)}Mn_aBr_{(4-y)}Cl_y$ ($0<a\leq0.7$, $0<y<4$), and the like, as preferable examples.

(Emission spectrum)

Perovskite compounds are luminous bodies that can emit fluorescence in the visible light wavelength region. When X is a bromide ion, fluorescence can be emitted in which the maximum peak of emission intensity is usually 480 nm or more, preferably 500 nm or more, more preferably 510 nm or more, and usually 700 nm or less, preferably 600 nm or less, and more preferably 580 nm or less.

The above upper limits and lower limits can be arbitrarily combined.

When X is an iodide ion, fluorescence can be emitted in which the maximum peak of emission intensity is usually 520 nm or more, preferably 530 nm or more, more preferably 540 nm or more, and usually 800 nm or less, preferably 750 nm or less, and more preferably 730 nm or less.

The above upper limits and lower limits can be arbitrarily combined.

When X is a chloride ion, fluorescence can be emitted in which the maximum peak of emission intensity is usually 300 nm or more, preferably 310 nm or more, more preferably 330 nm or more, and usually 600 nm or less, preferably 580 nm or less, more preferably 550 nm or less.

The above upper limits and lower limits can be arbitrarily combined.

The particle diameter of the component (1) contained in the composition is not particularly limited, and is preferably 1 nm or more, more preferably 2 nm or more, further preferably 3 nm or more, from the viewpoint of maintaining a good crystal structure. Further, from the viewpoint that the component (1) hardly precipitates in the composition, it is preferably 10 $\mu$m or less, more preferably 1 $\mu$m or less, and further preferably 500 nm or less.
The above upper limits and lower limits can be arbitrarily combined.
The particle size of the component (1) contained in the composition is not particularly limited, and the particle size is preferably 1 nm or more and 10 $\mu$m or less, more preferably from 2 nm or more and 1 $\mu$m or less, further preferably from 3 nm or more and 500 nm or less, from the viewpoint that the component (1) hardly precipitates and that the crystal structure is favorably maintained in the composition.
The particle size distribution of the component (1) contained in the composition is not particularly limited, and the median diameter $D_{50}$ is preferably 3 nm or more, more preferably 4 nm or more, and further preferably 5 nm or more, from the viewpoint of maintaining good crystalline structure. In addition, from the viewpoint that (1) hardly precipitates in the composition, it is preferably 5 $\mu$m or less, more preferably 500 nm or less, and further preferably 100 nm or less.

<<(2) Component>>

The component (2) is a compound represented by the formula (C) or a modified product thereof

[Chemical Formula 10]

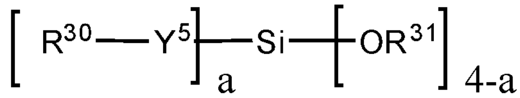

(C)

(In the formula (C), $Y^5$ represents a single bond, an oxygen atom or a sulfur atom.
(When $Y^5$ is an oxygen atom)
$R^{30}$ and $R^{31}$ each independently represent an alkyl group having 1 to 20 carbon atoms, a cycloalkyl group having 3 to 30 carbon atoms, an unsaturated hydrocarbon group having 2 to 20 carbon atoms, or a hydrogen atom.
(When $Y^5$ is a single bond or a sulfur atom)
$R^{30}$ is an alkyl group having 1 to 20 carbon atoms, a cycloalkyl group having 3 to 30 carbon atoms, or an unsaturated hydrocarbon group having 2 to 20 carbon atoms,
**[0113]** $R^{31}$ is an alkyl group having 1 to 20 carbon atoms, a cycloalkyl group having 3 to 30 carbon atoms, an unsaturated hydrocarbon group having 2 to 20 carbon atoms, or a hydrogen atom.
The hydrogen atoms in the alkyl group, the cycloalkyl group and the unsaturated hydrocarbon group represented by $R^{30}$ or $R^{31}$ described above may each independently be substituted with a halogen atom, and may each independently be substituted with an alkyl group, a cycloalkyl group, an unsaturated hydrocarbon group or an amino group as the substituent.
a is an integer of 1 to 3.
When a is 2 or 3, a plurality of $Y^5$ may be the same or different.
When a is 2 or 3, a plurality of $R^{30}$ may be the same or different.
When a is 1 or 2, a plurality of $R^{31}$ may be the same or different.
The compound represented by the above formula (C) may be modified with silica by the method described later to be used.
At least a part of the component (2) may be adsorbed on the component (1) contained in the composition or may be dispersed in the composition.
The alkyl group represented by $R^{30}$ and $R^{31}$ may be linear or branched.
When $Y^5$ is an oxygen atom, the number of carbon atoms of the alkyl group represented by $R^{30}$ is preferably 1 to 20, more preferably 1 to 3, and further preferably 1 because modification proceeds rapidly.
When $Y^5$ is a single bond or a sulfur atom, the number of carbon atoms of the alkyl group represented by $R^{30}$ is preferably 5 to 20, and more preferably 8 to 20.
$Y^5$ is preferably an oxygen atom because modification proceeds quickly.
The number of carbon atoms of the alkyl group represented by $R^{31}$ is preferably 1 to 5, more preferably 1 to 2, and further preferably 1 because modification proceeds rapidly.

The number of carbon atoms of the cycloalkyl group represented by $R^{30}$ and $R^{31}$ is preferably 3 to 20, and more preferably 3 to 11. The number of carbon atoms includes the number of carbon atoms in the substituent.

When the hydrogen atoms in the cycloalkyl group represented by $R^{30}$ and $R^{31}$ are each independently substituted with an alkyl group, the number of carbon atoms of the above-described cycloalkyl group is 4 or more. The alkyl group in which a hydrogen atom may be substituted in the above-described cycloalkyl group has 1 to 27 carbon atoms.

The unsaturated hydrocarbon group represented by $R^{30}$ and $R^{31}$ may be linear, branched, or cyclic.

The unsaturated hydrocarbon group represented by $R^{30}$ and $R^{31}$ has preferably 5 to 20 carbon atoms, and more preferably 8 to 20 carbon atoms.

$R^{30}$ is preferably an alkyl group or an unsaturated hydrocarbon group, and more preferably an alkyl group. $R^{31}$ is preferably a hydrogen atom, an alkyl group, or an unsaturated hydrocarbon group, and more preferably an alkyl group. The unsaturated hydrocarbon group represented by $R^{30}$ and $R^{31}$ is preferably an alkenyl group, and more preferably an alkenyl group having 8 to 20 carbon atoms.

Specific examples of the alkyl group of $R^{30}$ and $R^{31}$ include alkyl groups exemplified for the groups represented by $R^6$ to $R^9$.

Specific examples of the cycloalkyl group represented by $R^{30}$ and $R^{31}$ include cycloalkyl groups exemplified for the groups represented by $R^6$ to $R^9$.

As the alkenyl group of $R^6$ to $R^9$, exemplified are the above-described linear or branched alkyl groups as exemplified for $R^6$ to $R^9$ in which a single bond (C-C) between any one carbon atom is replaced by a double bond (C=C), and the position of the double bond is not limited.

Preferred examples of such an alkenyl group include, for example, an ethenyl group, a propenyl group, a 3-butenyl group, a 2-butenyl group, a 2-pentenyl group, a 2-hexenyl group, a 2-nonenyl group, a 2-dodecenyl group, and an 9-octadecenyl group.

When the alkyl group, the cycloalkyl group and unsaturated hydrocarbon group represented by $R^{31}$ have the above-mentioned number of carbon atoms, the compound represented by the formula (C) is easily hydrolyzed, and the silanol bonds formed can be further condensed from each other. Thereby, the compound represented by the formula (C) is easily adsorbed on the surface of the component (1). As a result, it is considered that the component (1) in the composition is less likely to deteriorate even in a hot environment and a composition having high durability can be obtained.

Examples of the halogen atom include a fluorine atom, a chlorine atom, a bromine atom, and an iodine atom, and a fluorine atom is preferable from the viewpoint of chemical stability.

Specific examples of the compound represented by the formula (C) include tetraethoxysilane, tetramethoxysilane, tetrabutoxysilane, tetraisopropoxysilane, 3-aminopropyltriethoxysilane, 3-aminopropyltrimethoxysilane, trimethoxyphenylsilane, ethoxytriethylsilane, methoxytrimethylsilane, methoxydimethyl(phenyl)silane, pentafluorophenylethoxydimethylsilane, trimethylethoxysilane, 3-chloropropyldimethoxymethylsilane, (3-chloropropyl)diethoxy(methyl) silane, (chloromethyl)dimethoxy(methyl)silane, (chloromethyl)diethoxy(methyl)silane, diethoxydimethylsilane, dimethoxydimethylsilane, dimethoxydiphenylsilane, dimethoxymethylphenylsilane, diethoxydiphenylsilane, dimethoxymethylvinylsilane, diethoxy(methyl)phenylsilane, dimethoxy(methyl)(3,3,3-trifluoropropyl)silane, allyltriethoxysilane, allyltrimethoxysilane, (3-bromopropyl)trimethoxysilane, cyclohexyltrimethoxysilane, (chloromethyl)triethoxysilane, (chloromethyl)trimethoxysilane, dodecyltriethoxysilane, dodecyltrimethoxysilane, triethoxyethylsilane, decyltrimethoxysilane, ethyltrimethoxysilane, hexyltriethoxysilane, hexyltrimethoxysilane, hexadecyltrimethoxysilane, trimethoxy(methyl)silane, triethoxymethylsilane, tetrabutoxysilane, tetrapropoxysilane, tetraisopropoxysilane, trimethoxy(1H,1H,2H,2H-heptadecafluorodecyl)silane, triethoxy-1H,1H,2H,2H-tridecafluoro-n-octylsilane, trimethoxy(1H,1H,2H,2H-nonafluorohexyl)silane, trimethoxy(3,3,3-trifluoropropyl)silane, 1H,1H,2H,2H-perfluorooctyltriethoxysilane and the like.

Among them, trimethoxyphenylsilane, methoxydimethyl(phenyl)silane, dimethoxydiphenylsilane, dimethoxymethylphenylsilane, cyclohexyltrimethoxysilane, dodecyltriethoxysilane, dodecyltrimethoxysilane, decyltrimethoxysilane, hexyltriethoxysilane, hexyltrimethoxysilane, hexadecyltrimethoxysilane, trimethoxy(1H,1H,2H,2H-heptadecafluorodecyl)silane, triethoxy-1H,1H,2H,2H-tridecafluoro-n-octylsilane, trimethoxy(1H,1H,2H,2H-nonafluorohexyl)silane, trimethoxy(3,3,3-trifluoropropyl)silane, 1H,1H,2H,2H-perfluorooctyltriethoxysilane, tetraethoxysilane, tetramethoxysilane, tetrabutoxysilane, and tetraisopropoxysilane are preferable, tetraethoxysilane, tetramethoxysilane, tetrabutoxysilane, and tetraisopropoxysilane are more preferable, and tetramethoxysilane is most preferable.

Further, as the compound represented by the formula (C), dodecyltrimethoxysilane, trimethoxyphenylsilane, 1H,1H,2H,2H-perfluorooctyltriethoxysilane, and trimethoxy(1H,1H,2H,2H-nonafluorohexyl)silane may also be used.

The component (2) may be a modified product of the compound represented by the formula (C), which is obtained by modifying the compound represented by the formula (C) by a method described below.

In the present specification, "modifying the compound represented by the formula (C)" means condensing two or more molecules of the compound represented by the formula (C) to form a Si-O-Si bond. Further, "the modified product of the compound represented by the formula (C)" refers to a compound (condensate) containing a Si-O-Si bond obtained by the above condensation reaction.

As the modified product of the compound represented by the formula (C), for example, a compound in which

at least one $R^{31}$ contained in the compound represented by the formula (C) is substituted with Si is preferable.

<<(3) Component>>

The component (3) is at least one compound selected from the group consisting of compounds represented by the formulas (X1) to (X3) and salts thereof.

[Chemical Formula 11]

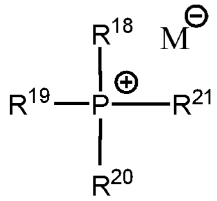

(X1)

[Chemical Formula 12]

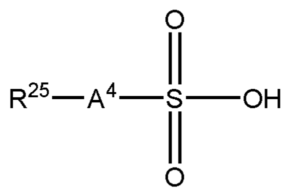

(X2)

[Chemical Formula 13]

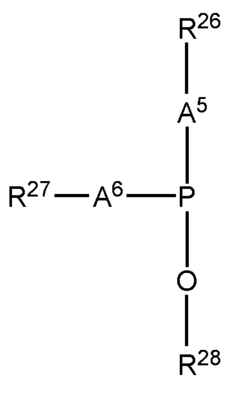

(X3)

(In the formula (X1), $R^{18}$ to $R^{21}$ each independently represent an alkyl group having 1 to 20 carbon atoms, a cycloalkyl

group having 3 to 30 carbon atoms, or an aryl group having 6 to 30 carbon atoms, and they optionally have a substituent. $M^-$ represents a counter anion.

In formula (X2), $A^4$ represents a single bond or an oxygen atom. $R^{25}$ represents an alkyl group having 1 to 12 carbon atoms, a cycloalkyl group having 3 to 30 carbon atoms, or an aryl group having 6 to 30 carbon atoms, and they optionally have a substituent.

In formula (X3), $A^5$ and $A^6$ each independently represent a single bond or an oxygen atom. $R^{26}$ to $R^{28}$ each independently represent an alkyl group having 1 to 20 carbon atoms, a cycloalkyl group having 3 to 30 carbon atoms, an aryl group having 6 to 30 carbon atoms, an alkenyl group having 2 to 20 carbon atoms, or an alkynyl group having 2 to 20 carbon atoms, and they optionally have a substituent.

The hydrogen atoms contained in the groups represented by $R^{18}$ to $R^{21}$ and $R^{25}$ to $R^{28}$ may be independently substituted with a halogen atom.).

<Compound represented by the formula (X1)>

In the formula (X1), $R^{18}$ to $R^{21}$ each independently represent an alkyl group having 1 to 20 carbon atoms optionally having a substituent, a cycloalkyl group having 3 to 30 carbon atoms optionally having a substituent, or an aryl group having 6 to 30 carbon atoms optionally having a substituent.

The alkyl group represented by $R^{18}$ to $R^{21}$ may be linear or branched, and preferably has a phenyl group, an alkyl group, or an aryl group as a substituent. The alkyl group represented by $R^{18}$ to $R^{21}$ usually has 1 to 20, preferably 5 to 20, and more preferably 8 to 20 carbon atoms. The number of carbon atoms includes the number of carbon atoms in the substituent.

The cycloalkyl group represented by $R^{18}$ to $R^{21}$ preferably has a phenyl group, an alkyl group, or an aryl group as a substituent. The cycloalkyl group represented by $R^{18}$ to $R^{21}$ usually has 3 to 30, preferably 3 to 20, and more preferably 3 to 11 carbon atoms. The number of carbon atoms includes the number of carbon atoms in the substituent.

The aryl group represented by $R^{18}$ to $R^{21}$ preferably has a phenyl group, an alkyl group, or an aryl group as a substituent. The number of carbon atoms of the aryl group represented by $R^{18}$ to $R^{21}$ is usually 6 to 30, preferably 6 to 20, and more preferably 6 to 10. The number of carbon atoms includes the number of carbon atoms in the substituent.

The groups represented by $R^{18}$ to $R^{21}$ are preferably alkyl groups.

Specific examples of the alkyl group represented by $R^{18}$ to $R^{21}$ include the alkyl groups exemplified for the alkyl group represented by $R^6$ to $R^9$.

Specific examples of the cycloalkyl group represented by $R^{18}$ to $R^{21}$ include the cycloalkyl groups exemplified for the cycloalkyl group represented by $R^6$ to $R^9$.

Specific examples of the aryl group represented by $R^{18}$ to $R^{21}$ include the aryl groups exemplified for the aryl group represented by $R^6$ to $R^9$.

The hydrogen atoms contained in the groups represented by $R^{18}$ to $R^{21}$ may be each independently substituted with a halogen atom, and examples of the halogen atom include a fluorine atom, a chlorine atom, a bromine atom and an iodine atom, and a fluorine atom is preferred from the viewpoint of chemical stability.

In the compound represented by the formula (X1), $M^-$ represents a counter anion, and preferred examples thereof include halide ions such as $Br^-$, $Cl^-$, $I^-$ and $F^-$, and carboxylate ions.

Specific examples of the compound represented by the formula (X1) include tributyl-n-octylphosphonium bromide, tetraphenylphosphonium chloride, tributylhexadecylphosphonium chloride, tetrabutylphosphonium chloride, tetraethylphosphonium chloride, and tetra-n-octylphosphonium chloride. , tetraphenylphosphonium bromide, tributylhexadecylphosphonium bromide, tetrabutylphosphonium bromide, tetraethylphosphonium bromide, tetra-n-octylphosphonium bromide, tributyldodecylphosphonium bromide, tributyl-n-octylphosphonium bromide, tetraphenylphosphonium iodide, tributylhexadecylphosphonium iodide, tetrabutylphosphonium iodide, tetraethylphosphonium iodide, tetra-n-octylphosphonium iodide, and tributyl-n-octylphosphonium bromide, and from the viewpoint of thermal durability of the composition, tributylhexadecylphosphonium bromide and tributyl-n-octylphosphonium bromide are preferable, and tributyl-n-octylphosphonium bromide is more preferred.

Part or all of the compound represented by the formula (X1) may be adsorbed on the surface of the perovskite compound according to the present invention, or may be dispersed in the composition.

<Compound represented by the formula (X2)>

In the compound represented by the formula (X2), $A^4$ represents a single bond or an oxygen atom.

In the compound represented by the formula (X2), $R^{25}$ represents an alkyl group having 1 to 20 carbon atoms optionally having a substituent, a cycloalkyl group having 3 to 30 carbon atoms optionally having a substituent, or an aryl group having 6 to 30 carbon atoms optionally having a substituent.

The alkyl group represented by $R^{25}$ may be linear or branched, and it is preferred to have a phenyl group, an

alkyl group or an aryl group as a substituent. The number of carbon atoms of the alkyl group represented by $R^{25}$ is usually 1 to 20, preferably 5 to 20, and more preferably 8 to 20. The number of carbon atoms includes the number of carbon atoms in the substituent.

The cycloalkyl group represented by $R^{25}$ preferably has a phenyl group, an alkyl group or an aryl group as a substituent. The number of carbon atoms of the cycloalkyl group represented by $R^{25}$ is usually 3 to 30, preferably 3 to 20, and more preferably 3 to 11. The cycloalkyl group represented by $R^{25}$ may have an alkyl group or an aryl group as a substituent. The number of carbon atoms includes the number of carbon atoms in the substituent.

The aryl group represented by $R^{25}$ preferably has a phenyl group, an alkyl group or an aryl group as a substituent. The number of carbon atoms of the aryl group represented by $R^{25}$ is usually 6 to 30, preferably 6 to 20, and more preferably 6 to 10. The number of carbon atoms includes the number of carbon atoms in the substituent.

The group represented by $R^{25}$ is preferably an alkyl group.

Specific examples of the alkyl group represented by $R^{25}$ include alkyl groups exemplified for the alkyl group represented by $R^6$ to $R^9$.

Specific examples of the cycloalkyl group represented by $R^{25}$ include cycloalkyl groups exemplified for the cycloalkyl group represented by $R^6$ to $R^9$.

Specific examples of the aryl group represented by $R^{25}$ include aryl groups exemplified for the aryl group represented by $R^6$ to $R^9$.

The hydrogen atom contained in the group represented by $R^{25}$ may be each independently substituted with a halogen atom, and examples of the halogen atom include a fluorine atom, a chlorine atom, a bromine atom, and an iodine atom, and from the viewpoint of chemical stability, a fluorine atom is preferred.

In the salt of the compound represented by the formula (X2), the anionic group is represented by the following formula (X2-1).

[Chemical Formula 14]

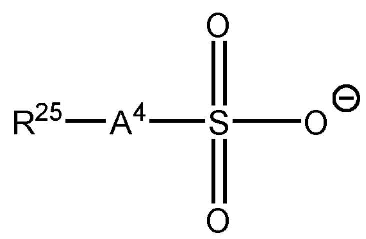

(X2-1)

In the salt of the compound represented by the formula (X2), examples of the cationic group forming the pair of the formula (X2-1) include an ammonium salt.

In the salt of the compound represented by the formula (X2), the counter cation to be paired with the formula (X2-1) is, for example, but not particularly limited to, a monovalent ion such as $Na^+$, $K^+$, $Cs^+$, $H^+$.

The salt of the compound represented by the formula (X2) includes sodium 1-octanesulfonate, sodium 1-decanesulfonate, sodium 1-dodecanesulfonate, sodium hexadecyl sulfate, sodium lauryl sulfate, sodium myristyl sulfate, sodium laureth sulfate, and sodium dodecyl sulfate, and from the viewpoint of the thermal durability of the composition, sodium hexadecyl sulfate and sodium dodecyl sulfate are preferred, and sodium dodecyl sulfate is more preferred.

Part or all of the compound represented by the formula (X2) or a salt thereof may be adsorbed on the surface of the perovskite compound according to the present invention, or may be dispersed in the composition.

<Compound represented by the formula (X3)>

In the compound represented by the formula (X3), $A^5$ and $A^6$ each independently represent a single bond or an oxygen atom.

In the compound represented by the formula (X3), $R^{26}$ to $R^{28}$ each independently represent an alkyl group having 1 to 20 carbon atoms optionally having a substituent, a cycloalkyl group having 3 to 30 carbon atoms optionally having a substituent, an aryl group having 6 to 30 carbon atoms optionally having a substituent, an alkenyl group having 2 to 20 carbon atoms optionally having a substituent, or an alkynyl group having 2 to 20 carbon atoms optionally having a substituent.

The alkyl groups represented by $R^{26}$ to $R^{28}$ may be each independently linear or branched, and preferably

have a phenyl group, an alkyl group, or an aryl group as a substituent. The alkyl group represented by $R^{26}$ to $R^{28}$ usually has 1 to 20, preferably 5 to 20, and more preferably 8 to 20 carbon atoms. The number of carbon atoms includes the number of carbon atoms in the substituent.

The cycloalkyl group represented by $R^{26}$ to $R^{28}$ preferably each independently have a phenyl group, an alkyl group or an aryl group as a substituent. The cycloalkyl group represented by $R^{26}$ to $R^{28}$ usually has 3 to 30, preferably 3 to 20, and more preferably 3 to 11 carbon atoms. The cycloalkyl group represented by $R^{26}$ to $R^{28}$ may have an alkyl group or an aryl group as a substituent. The number of carbon atoms includes the number of carbon atoms in the substituent.

The aryl group represented by $R^{26}$ to $R^{28}$ preferably each independently have a phenyl group, an alkyl group or an aryl group as a substituent. The number of carbon atoms of the aryl group represented by $R^{26}$ to $R^{28}$ is usually 6 to 30, preferably 6 to 20, and more preferably 6 to 10. The number of carbon atoms includes the number of carbon atoms in the substituent.

The alkenyl groups represented by $R^{26}$ to $R^{28}$ preferably each independently have a phenyl group, an alkyl group, or an aryl group as a substituent. The number of carbon atoms of the alkenyl group represented by $R^{26}$ to $R^{28}$ is usually 2 to 20, preferably 6 to 20, and more preferably 12 to 18. The number of carbon atoms includes the number of carbon atoms in the substituent.

The alkynyl group represented by $R^{26}$ to $R^{28}$ preferably each independently have a phenyl group, an alkyl group or an aryl group as a substituent. The number of carbon atoms of the alkynyl group represented by $R^{26}$ to $R^{28}$ is usually 2 to 20, preferably 6 to 20, and more preferably 12 to 18. The number of carbon atoms includes the number of carbon atoms in the substituent.

The groups represented by $R^{26}$ to $R^{28}$ are preferably each independently an alkyl group.

Specific examples of the alkyl group represented by $R^{26}$ to $R^{28}$ include alkyl groups exemplified for the alkyl group represented by $R^6$ to $R^9$.

Specific examples of the cycloalkyl group represented by $R^{26}$ to $R^{28}$ include cycloalkyl groups exemplified for the cycloalkyl group represented by $R^6$ to $R^9$.

Specific examples of the aryl group represented by $R^{26}$ to $R^{28}$ include aryl groups exemplified for the aryl group represented by $R^6$ to $R^9$.

Specific examples of the alkenyl group represented by $R^{26}$ to $R^{28}$ include hexenyl, octenyl, decenyl, dodecenyl, tetradecenyl, hexadecenyl, octadecenyl, and icosenyl.

Specific examples of the alkynyl group represented by $R^{26}$ to $R^{28}$ include hexynyl, octynyl, decynyl, dodecynyl, tetradecynyl, hexadecynyl, octadecynyl, and icosynyl.

The hydrogen atoms contained in the groups represented by $R^{26}$ to $R^{28}$ may be each independently substituted with a halogen atom, and examples of the halogen atom include a fluorine atom, a chlorine atom, a bromine atom and an iodine atom, and from the viewpoint of chemical stability, a fluorine atom is preferred.

The compound represented by the formula (X3) includes trioleyl phosphite, tributyl phosphite, triethyl phosphite trihexyl phosphite, triisodecyl phosphite, and trimethyl phosphite, and from the viewpoint of the thermal durability of the composition, trioleyl phosphite, and trihexyl phosphite are preferred, and trioleyl phosphite is more preferable.

Part or all of the compound represented by the formula (X3) may be adsorbed on the surface of the perovskite compound according to the present invention, or may be dispersed in the composition.

<<(4) Component>>

The component (4) is a solvent. The solvent is not particularly limited as long as it is a medium capable of dispersing the component (1), but a solvent that does not easily dissolve the component (1) is preferable.

Examples of the solvent include esters such as methyl formate, ethyl formate, propyl formate, pentyl formate, methyl acetate, ethyl acetate, and pentyl acetate; ketones such as γ-butyrolactone, N-methyl-2-pyrrolidone, acetone, dimethyl ketone, diisobutyl ketone, cyclopentanone, cyclohexanone, methylcyclohexanone, etc.; ethers such as diethyl ether, methyl-tert-butyl ether, diisopropyl ether, dimethoxymethane, dimethoxyethane, 1,4-dioxane, 1,3-dioxolan, 4-methyldioxolan, tetrahydrofuran, methyltetrahydrofuran, anisole, phenetole, etc.; alcohols such as methanol, ethanol, 1-propanol, 2-propanol, 1-butanol, 2-butanol, tert-butanol, 1-pentanol, 2-methyl-2-butanol, methoxypropanol, diacetone alcohol, cyclohexanol, 2-fluoroethanol, 2,2,2-trifluoroethanol, 2,2,3,3-tetrafluoro-1-propanol etc.; glycol ethers such as ethylene glycol monomethyl ether, ethylene glycol monoethyl ether, ethylene glycol monobutyl ether, ethylene glycol monoethyl ether acetate, triethylene glycol dimethyl ether, etc.; organic solvents having an amide group such as N,N-dimethylformamide, acetamide, N,N-dimethylacetamide, etc.; organic solvents having a nitrile group such as acetonitrile, isobutyronitrile, propionitrile, methoxyacetate nitrile, etc.; organic solvents having a carbonate group such as ethylene carbonate, propylene carbonate, etc.; organic solvents having a halogenated hydrocarbon group such as methylene chloride, chloroform, etc.; organic solvents having a hydrocarbon group such as n-pentane, cyclohexane, n-hexane, benzene, toluene, xylene, etc.; dimethylsulfoxide, 1-octadecene and the like.

Of them, esters such as methyl formate, ethyl formate, propyl formate, pentyl formate, methyl acetate, ethyl acetate, pentyl acetate, etc.; ketones such as γ-butyrolactone, acetone, dimethyl ketone, diisobutyl ketone, cyclopentanone, cyclohexanone, methyl cyclohexanone, etc.; ethers such as diethyl ether, methyl-tert-butyl ether, diisopropyl ether, dimethoxymethane, dimethoxyethane, 1,4-dioxane, 1,3-dioxolan, 4-methyldioxolan, tetrahydrofuran, methyltetrahydrofuran, anisole, phenetole, etc.; organic solvents having a nitrile group such as acetonitrile, isobutyronitrile, propionitrile, methoxyacetonitrile, etc.; organic solvents having a carbonate group such as ethylene carbonate, propylene carbonate, etc.; organic solvents having a halogenated hydrocarbon group such as methylene chloride, chloroform, etc.; and organic solvents having a hydrocarbon group such as n-pentane, cyclohexane, n-hexane, benzene, toluene, xylene, etc. are preferred because they have low polarity and are considered to be difficult to dissolve the component (1), and organic solvents having a halogenated hydrocarbon group such as methylene chloride, chloroform, etc.; and organic solvents having a hydrocarbon group such as n-pentane, cyclohexane, n-hexane, benzene, toluene, xylene, etc. are more preferred.

<<(5) Component>>

The component (5) is a polymerizable compound or a polymer.

The polymerizable compound contained in the composition of the present embodiment is not particularly limited, but preferably has low solubility of the component (1) in the polymerizable compound at the temperature at which the composition is manufactured.

For example, when produced at room temperature under atmospheric pressure, the polymerizable compound is not particularly limited, and known polymerizable compounds such as, for example, styrene, acrylic acid esters, methacrylic acid esters, acrylonitrile and the like are listed. Among them, the polymerizable compound is preferably an acrylate ester and/or a methacrylate ester, which are monomer components of an acrylic resin.

The polymer contained in the composition of the present embodiment is not particularly limited, but preferably has low solubility of the component (1) in the polymer at the temperature at which the composition is manufactured.

For example, when the polymer is produced at room temperature under normal pressure, the polymer is not particularly limited, and known polymers such as, for example, polystyrene, acrylic resins, epoxy resins and the like are mentioned. Among them, an acrylic resin is preferable as the polymer. The acrylic resin contains a constitutional unit derived from one or both of an acrylic ester and a methacrylic ester.

The amount of one or both of an acrylate ester and a methacrylate ester and constitutional units derived therefrom, among the constitutional units of the component (4), may be 10% or more, may be 30% or more, may be 50% or more, or may be 80% or more when represented by mol%.

<<(6) Component>>

The component (6) is at least one selected from the group consisting of ammonia, amines, and carboxylic acids, and salts or ions thereof.

The component (6) includes ammonia, amine, and carboxylic acid, and at least one selected from the group consisting of salts and ions of the compound as a possible form of the compound.

That is, the component (6) is at least one selected from the group consisting of ammonia, amine, carboxylic acid, salt of ammonia, salt of amine, salt of carboxylic acid, ion of ammonia, ion of amine, and ion of carboxylic acid.

Ammonia, amines, and carboxylic acids, and their salts or ions usually act as capping ligands. The capping ligand is a compound having an action of adsorbing on the surface of the component (1) and dispersing the component (1) stably in the composition. The ion or salt (such as an ammonium salt) of ammonia or an amine includes an ammonium cation represented by the following general formula (A1) and an ammonium salt containing the same. The carboxylic acid ion or salt (carboxylate or the like) includes a carboxylate anion represented by the following general formula (A2) and a carboxylate containing the carboxylate anion. The composition of the present embodiment may contain one of an ammonium salt or the like, a carboxylate or the like, or may contain both.

The component (6) may be an ammonium cation represented by the general formula (A1) or an ammonium salt containing the same.

[Chemical Formula 15]

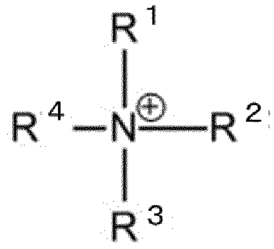

(A1)

In the general formula (A1), $R^1$ to $R^3$ represent a hydrogen atom, and $R^4$ represents a hydrogen atom or a monovalent hydrocarbon group. The hydrocarbon group represented by $R^4$ may be a saturated hydrocarbon group (an alkyl group or a cycloalkyl group) or may be an unsaturated hydrocarbon group.
The alkyl group represented by $R^4$ may be linear or branched.
The number of carbon atoms of the alkyl group represented by $R^4$ is usually 1 to 20, preferably 5 to 20, and more preferably 8 to 20.
The cycloalkyl group represented by $R^4$ may have an alkyl group as a substituent. The number of carbon atoms of the cycloalkyl group is usually 3 to 30, preferably 3 to 20, and more preferably 3 to 11. The number of carbon atoms includes the number of carbon atoms in the substituent.
The unsaturated hydrocarbon group for $R^4$ may be linear or branched.
The number of carbon atoms of the unsaturated hydrocarbon group for $R^4$ is usually 2 to 20, preferably 5 to 20, and more preferably 8 to 20.
$R^4$ is preferably a hydrogen atom, an alkyl group, or an unsaturated hydrocarbon group. As the unsaturated hydrocarbon group, an alkenyl group is preferable. $R^4$ is preferably an alkenyl group having 8 to 20 carbon atoms.
Specific examples of the alkyl group of $R^4$ include alkyl groups exemplified for $R^6$ to $R^9$.
Specific examples of the cycloalkyl group of $R^4$ include cycloalkyl groups exemplified for $R^6$ to $R^9$.
As the alkenyl group of $R^4$, exemplified are the above-described linear or branched alkyl groups as exemplified for $R^6$ to $R^9$ in which a single bond (C-C) between any one carbon atom is replaced by a double bond (C=C), and the position of the double bond is not limited.
Preferred examples of such an alkenyl group include, for example, an ethenyl group, a propenyl group, a 3-butenyl group, a 2-butenyl group, a 2-pentenyl group, a 2-hexenyl group, a 2-nonenyl group, a 2-dodecenyl group, and an 9-octadecenyl group.
When the ammonium cation forms a salt, the counter anion is not particularly limited, but preferred examples thereof include halides such as $Br^-$, $Cl^-$, $I^-$, and $F^-$, and carboxylate ions, and the like.
Preferred examples of the ammonium salt having an ammonium cation represented by the general formula (A1) and a counter anion include n-octyl ammonium salt and oleyl ammonium salt.
The component (5) may be a carboxylate anion represented by the general formula (A2) or a carboxylate containing it.

$$R^5\text{-}CO_2^- \qquad (A2)$$

In the general formula (A2), $R^5$ represents a monovalent hydrocarbon group. The hydrocarbon group represented by $R^5$ may be a saturated hydrocarbon group (alkyl group, a cycloalkyl group) or may be an unsaturated hydrocarbon group.
The alkyl group represented by $R^5$ may be linear or branched. The number of carbon atoms of the alkyl group represented by $R^5$ is usually 1 to 20, preferably 5 to 20, and more preferably 8 to 20.
The cycloalkyl group represented by $R^5$ may have an alkyl group as a substituent. The number of carbon atoms of the cycloalkyl group is usually 3 to 30, preferably 3 to 20, and more preferably 3 to 11. The number of carbon atoms includes also the number of carbon atoms in the substituent.
The unsaturated hydrocarbon group represented by $R^5$ may be linear or branched.
The unsaturated hydrocarbon group represented by $R^5$ usually has 2 to 20, preferably 5 to 20, and more preferably 8 to 20 carbon atoms.
$R^5$ is preferably an alkyl group or an unsaturated hydrocarbon group. As the unsaturated hydrocarbon group, an alkenyl group is preferable.
Specific examples of the alkyl group for $R^5$ include alkyl groups exemplified for $R^6$ to $R^9$.

Specific examples of the cycloalkyl group for $R^5$ include cycloalkyl groups exemplified for $R^6$ to $R^9$.
Specific examples of the alkenyl group for $R^5$ include alkenyl groups exemplified for $R^4$.
The carboxylate anion represented by the general formula (A2) is preferably an oleate anion.
When the carbochelate anion forms a salt, the counter cation is not particularly limited, but preferred examples thereof include a proton, an alkali metal cation, an alkaline earth metal cation, an ammonium cation and the like.

<About the compounding ratio of each component>

In the composition of the embodiment, the compounding ratio of the component (1) to the component (2) may be such that the component (2) exerts the effect of improving the durability against water vapor, and the compounding ratio can be appropriately determined depending on the types of the components (1)(2) and the like.
In the composition of the embodiment, the molar ratio [Si/B] between B in the component (1) and the Si element in the component (2) may be from 0.001 to 2,000, may be 0.01 to 500, or may be 1 to 100.
The composition in which the range of the compounding ratio of the component (1) and the component (2) is within the above range is preferable because the action of the component (2) for improving the thermal durability is particularly well exhibited.
In the composition of the embodiment, the compounding ratio of the component (1) and the component (3) can be appropriately determined according to the types of the component (1) and the following component (3).
(3) Component: at least one selected from the group consisting of compounds represented by the formulae (X1) to (X3) and salts thereof.
In the composition of the embodiment, the molar ratio [(X1)/B] between the metal ion B contained in the component (1) and the P element contained in the compound represented by the formula (X1) is preferably from 0.001 to 100, more preferably from 0.005 to 5, and further preferably from 0.2 to 2.
In the composition of the embodiment, the molar ratio [(X2)/B] between B which is a metal ion contained in the component (1) and the P element contained in the compound represented by the formula (X2), or between B which is a metal ion in the component (1) and the P element contained in the salt of the compound represented by the formula (X2) is preferably 1 to 100, more preferably 5 to 50, further preferably 10 to 30.
In the composition of the embodiment, the molar ratio [(X3)/B] between B which is a metal ion contained in the component (1) and the P element contained in the compound represented by the formula (X3) is preferably from 0.1 to 100, more preferably from 0.2 to 20, further preferably 0.3 to 15.
A composition in which the range related to the compounding ratio of the component (1) and the component (3) is within the above range is preferable in that the effect of thermal durability is exhibited particularly well.
In the composition of the embodiment, the compounding ratio of (1) and the sum of (4) and (5) may be such that the light emitting action by (1) is sufficiently exhibited, and the compounding ratio can be appropriately determined depending on the types of (1) to (5) and the like.
In the composition of the embodiment including (1), (2), and (3), and at least one selected from the group consisting of (4) and (5), the mass ratio [(1)/(total of (4) and (5))] between (1) and the total of (4) and (5) may be from 0.00001 to 10, may be from 0.0001 to 2, or may be from 0.0005 to 1.
A composition in which the range related to the compounding ratio of (1) and the total of (4) and (5) is within the above range is preferable in that the component (1) hardly coagulates and luminescence is also exhibited well.
In the composition of the present embodiment, the compounding ratio of (1) and (6) may be such that the light emitting action by (1) is sufficiently exhibited, and the compounding ratio can be appropriately determined depending on the types of (1) to (3) and (6) and the like.
In the composition of the embodiment containing (1), (2), (3), and (6), the molar ratio [(1)/(6)] between (1) and (6) may be 0.0001 to 1000, or may be 0.01 to 100.
A resin composition in which the range related to the compounding ratio of (1) and (6) is within the above range is preferable in that the component (1) hardly coagulates and also luminescence is exhibited well.

<<Method of producing composition>>

Hereinafter, embodiments of the method of producing a composition according to the present invention will be described. According to the method of producing the composition of the embodiment, the composition of the embodiment according to the present invention can be produced. The composition of the present invention is not limited to those manufactured by the method of producing a composition of the following embodiment.

((1) Method of producing perovskite compound having A, B and X)

The perovskite compound can be produced by the method described below with reference to known documents

(Nano Lett. 2015, 15, 3692-3696, ACSNano, 2015, 9, 4533-4542).

(First embodiment of method of producing perovskite compound having A, B, and X)

For example, the method of producing a perovskite compound according to the present invention includes a production method containing a step of dissolving B, X, and A in a solvent x to obtain a solution g, and a step of mixing the resultant solution g and a solvent y in which the solubility of the perovskite compound in the solvent is lower than the solvent x used in the step of obtaining the solution g. More specifically mentioned is a production method containing a step of dissolving a compound containing B and X and a compound containing A or A and X in a solvent x to obtain a solution g, and a step of mixing the resultant solution g and a solvent y in which the solubility of the perovskite compound in the solvent is lower than the solvent x used in the step of obtaining the solution g.

Hereinafter, the production method containing a step of dissolving a compound containing B and X and a compound containing A or A and X in a solvent x to obtain a solution g, and a step of mixing the resultant solution g and a solvent y in which the solubility of the perovskite compound in the solvent is lower than the solvent x used in the step of obtaining the solution g will be explained.

In the present specification, the solubility means the solubility at the temperature at which the mixing step is performed.

The production method preferably includes a step of adding a capping ligand from the viewpoint of stably dispersing the perovskite compound. The capping ligand is preferably added before the above-mentioned mixing step, and the capping ligand may be added to the solution g in which A, B, and X have been dissolved, or may be added to a solvent y in which the solubility of the perovskite compound in the solvent is lower than the solvent x used in the step of obtaining the solution g, or may be added to both the solvent x and the solvent y.

The production method preferably includes a step of removing coarse particles by a technique such as centrifugation or filtration after the mixing step described above. The size of the coarse particles to be removed in the removing step is preferably 10 μm or more, more preferably 1 μm or more, and particularly preferably 500 nm or more.

The above-mentioned step of mixing the solution g and the solvent y may be (I) a step of dropping the solution g to the solvent y, or (II) a step of dropping the solvent y to the solution g, however, from the viewpoint of enhancing the dispersibility of (1), (I) is preferable.

When dropping, stirring is preferable from the viewpoint of increasing the dispersibility of the component (1).

In the step of mixing the solution g and the solvent y, the temperature is not particularly limited, but from the viewpoint of ensuring the ease of precipitation of the component (1), the temperature is preferably in the range of -20°C to 40°C, more preferably in the range of -5°C to 30°C.

The two types of solvents x and y having different solubilities in the solvent of the perovskite compound used in the production method are not particularly limited, and include two types solvents selected from the group consisting of, for example, alcohols such as methanol, ethanol, 1-propanol, 2-propanol, 1-butanol , 2-butanol, tert-butanol, 1-pentanol, 2-methyl-2-butanol, methoxypropanol, diacetone alcohol, cyclohexanol, 2-fluoroethanol, 2,2,2-trifluoroethanol, 2,2,3,3-tetrafluoro-1-propanol, etc.; glycol ethers such as ethylene glycol monomethyl ether, ethylene glycol monoethyl ether, ethylene glycol monobutyl ether, ethylene glycol monoethyl ether acetate, triethylene glycol dimethyl ether, etc.; organic solvents having an amide group such as N, N-dimethylformamide, acetamide, N, N-dimethylacetamide, etc.; esters such as methyl formate, ethyl formate, propyl formate, pentyl formate, methyl acetate, ethyl acetate, pentyl acetate, etc.; ketones such as γ-butyrolactone, N-methyl-2-pyrrolidone, acetone, dimethyl ketone, diisobutyl ketone, cyclopentanone, cyclohexanone, methylcyclohexanone, etc.; ethers such as diethyl ether, methyl-tert-butyl ether, diisopropyl ether, dimethoxymethane, dimethoxyethane, 1,4-dioxane, 1,3-dioxolan, 4-methyldioxolan, tetrahydrofuran, methyltetrahydrofuran, anisole, phenetole, etc.; organic solvents having a nitrile group such as acetonitrile, isobutyronitrile, propionitrile, methoxyacetonitrile, etc.; organic solvents having a carbonate group such as ethylene carbonate, propylene carbonate, etc.; organic solvents having a halogenated hydrocarbon group such as methylene chloride, chloroform, etc.; organic solvents having a hydrocarbon group such as n-pentane, cyclohexane, n-hexane, benzene, toluene, xylene, etc.; and dimethyl sulfoxide.

As the solvent x used in the step of obtaining the solution g included in the production method, a solvent having high solubility in the solvent of the perovskite compound is preferable, and for example, when the step is performed at room temperature (10°C to 30°C), alcohols such as methanol, ethanol, 1-propanol, 2-propanol, 1-butanol, 2-butanol, tert-butanol, 1-pentanol, 2-methyl-2-butanol, methoxypropanol, diacetone alcohol, cyclohexanol, 2-fluoroethanol, 2,2,2-trifluoroethanol, 2,2,3,3-tetrafluoro-1-propanol, etc.; glycol ethers such as ethylene glycol monomethyl ether, ethylene glycol monoethyl ether, ethylene glycol monobutyl ether, ethylene glycol monoethyl ether acetate, triethylene glycol dimethyl ether, etc.; organic solvents having an amide group such as N, - dimethylformamide, acetamide, N, N- dimethylacetamide, etc., and dimethyl sulfoxide are mentioned.

As the solvent y used in the mixing step included in the production method, a solvent having low solubility in the solvent of the perovskite compound is preferable, and for example, when the step is performed at room temperature

(10°C to 30°C), the solvent includes esters such as methyl formate, ethyl formate, propyl formate, pentyl formate, methyl acetate, ethyl acetate, pentyl acetate, etc.; ketones such as γ-butyrolactone, N-methyl-2-pyrrolidone, acetone, dimethyl ketone, diisobutyl ketone, cyclopentanone, cyclohexanone, methylcyclohexanone, etc.; ethers such as diethyl ether, methyl-tert-butyl ether, diisopropyl ether, dimethoxymethane, dimethoxyethane, 1,4-dioxane, 1,3-dioxolan, 4-methyldioxolan, tetrahydrofuran, methyltetrahydrofuran, anisole, phenetol, etc.; organic solvents having a nitrile group such as acetonitrile, isobutyronitrile, propionitrile, methoxyacetonitrile, etc.; organic solvents having a carbonate group such as ethylene carbonate, propylene carbonate, etc.; organic solvents having a halogenated hydrocarbon group such as methylene chloride, chloroform, etc.; organic solvents having a hydrocarbon group such as n-pentane, cyclohexane, n-hexane, benzene, toluene, xylene, etc.

The difference between the two types of solvents having different solubilities is preferably 100 μg/solvent 100 g to 90 g/ solvent 100 g, more preferably 1 mg/solvent 100 g to 90 g/solvent 100 g. From the viewpoint of making the difference in solubility 100 μg/solvent 100 g or more and 90 g/solvent 100 g or less, for example, when performing the mixing process at room temperature (10°C or more and 30°C or less), it is preferable that the solvent x used in the step of obtaining a solution is an organic solvent having an amide group such as N,N-dimethylacetamide or dimethyl sulfoxide, and the solvent y used in the mixing step is an organic solvent having a halogenated hydrocarbon group such as methylene chloride, chloroform, etc.; or an organic solvent having a hydrocarbon group such as n-pentane, cyclohexane, n-hexane, benzene, toluene, xylene, etc.

As a method of extracting the perovskite compound from the obtained dispersion containing the perovskite compound, a method of performing solid-liquid separation to recover only the perovskite compound can be mentioned.

Examples of the solid-liquid separation method include a method such as filtration and a method utilizing evaporation of a solvent.

(Second embodiment of method of producing perovskite compound having A, B, and X)

The method of producing the perovskite compound may be a production method containing a step of adding and dissolving B, X and A in a high-temperature solvent z to obtain a solution h, and a step of cooling the obtained solution h. More specifically mentioned is a production method containing a step of adding and dissolving a compound containing B and X, and a compound containing A or a compound containing A and X in a solvent z of high temperature to obtain a solution h, and a step of cooling the resultant solution h.

The step of adding and dissolving a compound containing B and X, and a compound containing A or A and X in a solvent z of high temperature to obtain a solution h may be a step of adding a compound containing B and X, and a compound containing A or A and X in a solvent z, then, heating to obtain a solution h.

In this production method, the perovskite compound according to the present invention can be precipitated by the difference in solubility due to the difference in temperature, and the perovskite compound according to the present invention can be produced.

The production method preferably includes a step of adding a capping ligand from the viewpoint of stably dispersing the perovskite compound. The capping ligand is preferably contained in the solution h before the above-mentioned cooling step.

Preferably, this production method includes a step of removing coarse particles by a technique such as centrifugation or filtration after the step of cooling. The size of the coarse particles to be removed in the removal step is preferably 10 μm or more, more preferably 1 μm or more, and particularly preferably 500 nm or more.

Here, the high-temperature solvent z may be a solvent at a temperature at which the compound containing B and X and the compound containing A or A and X dissolve, and for example, a solvent of 60°C or more and 600°C or less is preferable, and a solvent of 80°C or more and 400°C or less is more preferable.

The cooling temperature is preferably from -20°C to 50°C, more preferably from -10°C to 30°C.

The solvent z used in this production method is not particularly limited as long as it can dissolve the compound containing B and X and the compound containing A or A and X. For example, the solvent described in the above (3) can be used.

As a method of extracting the perovskite compound from the obtained dispersion containing the perovskite compound, a method of performing solid-liquid separation to recover only the perovskite compound can be mentioned.

The above-described solid-liquid separation method includes a method such as filtration and a method utilizing evaporation of a solvent.

(Method of producing composition containing component (1), component (2), component (3), and component (4))

The method of producing the composition containing the component (1), the component (2), the component (3), and the component (4) may be, for example, the following production method (a1) or the following production method (a2).

Production method (a1): a method of producing a composition containing a step of mixing the component (1) and the component (4), and a step of mixing the mixture of the component (1) and the component (4), and the component (2), and the component (3).

Production method (a2): a method of producing a composition containing a step of mixing the component the component (1), the component (2) and the component (3), and a step of mixing the mixture of the component (1), the component (2) and the component (3), and the component (4).

In the production method (a1), the component (1) is preferably dispersed in the component (4). The production method (a1) may be, for example, a method of producing a composition containing a step of dispersing the component (1) in the component (4) to obtain a dispersion, and a step of mixing the dispersion, and the component (2) and the component (3).

In the embodiment, when producing a composition containing the modified product of the following (2'), the following production method (a3) or the production method (a4) may be used.

(2') Component: a compound represented by the formula (C)

Production method (a3): a method of producing a composition containing a step of mixing the component (1) and the component (4), a step of mixing the mixture of the component (1) and the component (4), and the component (2') and the component (3), and a step of performing a modification treatment on the mixture containing the component (1), the component (2'), the component (3) and the component (4).

Production method (a4): a method of producing a composition containing a step of mixing the component (1), the component (2') and the component (3), a step of mixing the mixture of the component (1), the component (2') and the component (3), and the component (4), and a step of performing a modification treatment on the mixture of the component (1), the component (2'), the component (3) and the component (4).

In the mixing step included in the above-described production method, stirring is preferable from the viewpoint of improving dispersibility.

In the mixing step included in the above-described production method, the temperature is not particularly limited, but is preferably in the range of 0°C to 100°C, and more preferably in the range of 10°C to 80°C, from the viewpoint of uniform mixing.

The method of producing the composition is preferably the production method (a1) or the production method (a3) from the viewpoint of improving the dispersibility of the component (1).

(Method for performing modification treatment on compound represented by the formula (C))

The method of performing the modification treatment on a compound represented by the formula (C) included in the above-described production method is not particularly restricted as long as two or more molecules of the compound represented by the formula (C) are condensed by at least partial Si-O-$R^3$ bonds included respectively, and a Si-O-Si bond is formed. Examples of the method of performing the modification treatment include known methods such as a method of reacting a compound represented by the formula (C) with water vapor, and the like.

Above all, it is preferable to perform a modification treatment by reacting a compound represented by the formula (C) with water vapor (hereinafter, sometimes referred to as humidification treatment) from the viewpoint of forming a stronger protective region near the component (1).

When performing the humidification treatment, for example, the composition may be left standing or stirred for a certain time under the temperature and humidity conditions described below.

The temperature in the humidification treatment may be a temperature at which the modification proceeds sufficiently. For example, it is preferably 5 to 150°C, more preferably 10 to 100°C, and further preferably 15 to 80°C.

The humidity in the humidification treatment may be a humidity at which moisture is sufficiently supplied to the compound represented by the formula (C) in the composition, for example, it is 30% to 100%, preferably 40% to 95%, and more preferably 60% to 90%.

The time required for the humidification treatment is not particularly limited as long as the modification proceeds sufficiently, and it is, for example, 10 minutes to 1 week, preferably 1 hour to 5 days, more preferably 12 hours to 3 days.

From the viewpoint of increasing the dispersibility of the compound represented by the formula (C) contained in the composition, it is preferable to stir it.

In the embodiment, the component (2), the component (3), and the component (4) may be mixed in any of the steps included in the method of producing the component (1) described above. For example, the following production method (a5) or the following production method (a6) may be adopted.

Production method (a5): a production method containing a step of dissolving a compound containing B and X, a compound containing A or A and X, and the component (2) and the component (3) in the component (4) to obtain a solution g, and a step of mixing the resultant solution g and a solvent y in which the solubility of the perovskite compound in the solvent is lower than the component (3) used in the step of obtaining a solution.

Production method (a6): a production method containing a step of adding and dissolving a compound containing

B and X, a compound containing A or A and X, and the component (2) and the component (3) in the component (4) of high temperature to obtain a solution h, and a step of cooling the resultant solution h.

The conditions of each step included in these production methods are the same as those described in the first and second embodiments of the method of producing a perovskite compound described above.

(Method of producing composition containing component (1), component (2), component (3), component (4), and component (6))

For example, a method of producing a composition containing the component (1), the component (2), the component (3), the component (4), and the component (6) can be the same production method of a composition containing the component (1), the component (2), the component (3) and the component (4), except that the component (6) is mixed in any step included in the above-described production methods (a1) to (a4).

In the present embodiment, from the viewpoint of enhancing the dispersibility of the component (1), it is preferable that the component (6) is mixed in any of the above-described steps included in the above-described methods of producing a perovskite compound having the components A, B, and X of the component (1). For example, it is preferable to produce by any of the following production methods (b1) to (b4).

Production method (b1): a production method containing a step of dissolving a compound containing B and X, a compound containing A or A and X, the component (2), the component (3), and the component (6) in the component (4) to obtain a solution g, and a step of mixing the resultant solution g and a solvent y in which the solubility of the perovskite compound in the solvent is lower than the component (3) used in the step of obtaining the solution.

Production method (b2): a production method containing a step of adding and dissolving a compound containing B and X, a compound containing A or A and X, the component (2), the component (3) and the component (6) in the component (4) of high temperature to obtain a solution h, and a step of cooling the resultant solution h.

Production method (b3): a production method containing a step of dissolving a compound containing B and X, a compound containing A or A and X, the component (2’), the component (3), and the component (6) in the component (4) to obtain a solution g, a step of mixing the resultant solution g and a solvent y in which the solubility of the perovskite compound in the solvent is lower than the component (4) used in the step of obtaining the solution, and a step of performing a modification treatment on the mixture of the component (1), the component (2’), the component (3), the component (4) and the component (6).

Production method (b4): a production method containing a step of adding and dissolving a compound containing B and X, a compound containing A or A and X, the component (2’), the component (3), and the component (6) in the component (4) of high temperature to obtain a solution h, a step of cooling the resultant solution h, and a step of performing a modification treatment on the cooled solution h containing the component (1), the component (2’), the component (3), the component (4) and the component (6).

(Method of producing composition containing component (1), component (2), component (3), and component (5))

The method of producing a composition containing the component (1), the component (2), the component (3), and the component (5) includes a method of mixing the component (1), the component (2), the component (3), and the component (5).

The step of mixing the component (1), the component (2), the component (3), and the component (5) is preferably performed with stirring from the viewpoint of increasing the dispersibility of the component (1).

In the step of mixing the component (1), the component (2), the component (3), and the component (5), the temperature is not particularly limited, but from the viewpoint of uniform mixing, the temperature is preferably in the range of 0°C or more and 100°C or less, more preferably in the range of 10°C or more and 80°C or less.

Examples of the method of producing a composition containing the component (1), the component (2), the component (3), and the component (5) include the following production methods (c1) to (c3).

Production method (c1): a production method containing a step of dispersing the component (1) in the component (5) to obtain a dispersion, and a step of mixing the resultant dispersion, and the component (2) and the component (3).

Production method (c2): a production method containing a step of dispersing the components (2) and (3) in the component (5) to obtain a dispersion, and a step of mixing the resultant dispersion and the component (1).

Production method (c3): a production method containing a step of dispersing a mixture of the component (1), the component (2) and the component (3) in the component (5).

Of the production methods (c1) to (c3), the production method (c1) is preferable from the viewpoint of enhancing the dispersibility of the component (1).

In the step of obtaining each dispersion included in the production methods (c1) to (c3), the component (5) may be added dropwise to the component (1), the component (2) and/or the component (3), or any one or all of the component (1), the component (2), and the component (3) may be dropped on the component (5).

From the viewpoint of enhancing dispersibility, it is preferable to drop one or all of the component (1), the component (2), and the component (3) to the component (5).
In each mixing step included in the production methods (c1) to (c3), the component (1), the component (2), or the component (3) may be dropped into the dispersion, or the dispersion may be dropped into the component (1), the component (2), or the component (3).
From the viewpoint of improving dispersibility, it is preferable to drop the component (1), the component (2), or the component (3) into the dispersion.
When a polymer is employed as the component (5), the polymer may be a polymer dissolved in a solvent.
The solvent in which the above-described polymer is dissolved is not particularly limited as long as it is a solvent that can dissolve the polymer (resin), but a solvent in which the component (1) used in the present invention is hardly dissolved is preferable.
As the solvent in which the above-described polymer is dissolved, for example, the solvent described as the component (4) can be used.
The method of producing a composition containing the components (1), (2), (3) and (5) may be the following production method (c4) or may be the following production (c5).
Production method (c4): a production method of a composition containing a step of dispersing the component (1) in the component (4) to obtain a dispersion, a step of mixing the resultant dispersion and the component (5) to obtain a mixed liquid, and a step of mixing the resultant mixed liquid, the component (2) and the component (3).
Production method (c5): a production method of a composition containing a step of dispersing the component (1) in the component (4) to obtain a dispersion, a step of mixing the dispersion, the component (2') and the component (3) to obtain a mixed liquid, a step of performing a modification treatment on the mixed liquid to obtain a mixed liquid containing the modified product of silazane, and a step of mixing the mixed liquid containing the silazane and the component (4).

(Method of producing composition containing component (1), component (2), component (3), component (5), and component (6))

The method of producing a composition containing the component (1), the component (2), the component (3), the component (5), and the component (6) can be the same method as the production method of a composition containing the component (1), the component (2), the component (3) and the component (4) already explained, except that the component (6) is added.
The component (6) may be added in any step included in the method of producing a perovskite compound having A, B, and X of the component (1), and may be added in any step included in the method of producing a composition containing the component (1), the component (2), the component (3) and the component (6) described above.
The component (6) is preferably added in any of the steps included in the method of producing a perovskite compound having A, B, and X of the components (1), from the viewpoint of enhancing the dispersibility of the component (1).
In the method of producing a composition containing the component (1), the component (2), the component (3), the component (5), and the component (6), a solvent for the component (4) may be used, and by this, a composition of the present embodiment can be obtained, for example, as a mixture of a dispersion in which the component (1) at least partially coated with the component (6) is dispersed in the component (4), a dispersion in which the component (2) and the component (3) are dispersed in the component (4), and the component (5), or as a mixture of a dispersion in which the component (1) at least partially coated with the component (6), and the component (2) and the component (3) are dispersed in the component (4), and the component (5).

(Method of producing composition containing component (1), component (2), component (3) and component (5') and in which the total of component (1), component (2), component (3) and component (5') is 90% by mass or more)

The method of producing a composition containing the component (1), the component (2), the component (3) and the component (5') and in which the total of the component (1), the component (2), the component (3) and the component (5') is 90% by mass or more includes, for example, the following production method (Y).
Production method (Y): a production method containing a step of mixing the component (1), the component (2), the component (3), and a polymerizable compound, and a step of polymerizing the polymerizable compound, and a production method containing a step of mixing the component (1), the component (2), the component (3) and a polymer dissolved in a solvent, and a step of removing the solvent.
In the mixing step included in the production method, a mixing method similar to the production method of a composition containing the component (1), the component (2), the component (3), and the component (5) described already can be used.

Examples of the production method include the following production methods (d1) to (d6).

Production method (d1): a production method containing a step of dispersing the component (1) in a polymerizable compound to obtain a dispersion, a step of mixing the resultant dispersion, the component (2), and the component (3), and a step of polymerizing the polymerizable compound.
Production method (d2): a production method containing a step of dispersing the component (1) in a polymer dissolved in a solvent to obtain a dispersion, a step of mixing the resultant dispersion, the component (2) and the component (3), and a step of removing the solvent.
Production method (d3): a production method containing a step of dispersing the component (2) and the component (3) in a polymerizable compound to obtain a dispersion, a step of mixing the resultant dispersion and the component (1), and a step of polymerizing the polymerizable compound.
Production method (d4): a production method containing a step of dispersing component (2) and component (3) in a polymer dissolved in a solvent to obtain a dispersion, a step of mixing the resultant dispersion and the component (1), and a step of removing the solvent.
Production method (d5): a production method containing a step of dispersing a mixture of the component (1), the component (2) and the component (3) in a polymerizable compound, and a step of polymerizing the polymerizable compound.
Production method (d6): a production method containing a step of dispersing a mixture of the component (1), the component (2) and the component (3) in a polymer dissolved in a solvent, and a step of removing the solvent.

The step of removing the solvent, which is included in the production method, may be a step of allowing to stand at room temperature and naturally drying, or a step of evaporating the solvent by drying under reduced pressure using a vacuum dryer or heating.
For example, the solvent can be removed by drying at 0°C to 300°C for 1 minute to 7 days.
The step of polymerizing the polymerizable compound included in the production method can be performed by appropriately using a known polymerization reaction such as radical polymerization.
For example, in the case of radical polymerization, a radical polymerization initiator is added to a mixture of the component (1), the component (2), the component (3), and the polymerizable compound to generate radicals, so that the polymerization reaction can proceed.
The radical polymerization initiator is not particularly limited, and examples thereof include a photo-radical polymerization initiator.
Examples of the photoradical polymerization initiator include bis(2,4,6-trimethylbenzoyl)-phenylphosphine oxide and the like.

(Method of producing composition containing component (1), component (2), component (3), component (5'), and component (6) in which the total of component (1), component (2), component (3), component (5') and component (6) is 90% by mass or more)

The method of producing a composition containing the component (1), the component (2), the component (3), the component (5'), and the component (6) in which the total of the component (1), the component (2), the component (3), the component (5') and the component (6) is 90% by mass or more can be the same as the production method of a composition containing the component (1), the component (2), the component (3) and the component (5') in which the total of the component (1), the component (2), the component (3) and the component (5') is 90% by mass or more already explained, except that the component (6) is added, for example, in any steps contained in the production method of a composition containing the component (1), the component (2), the component (3) and the component (5') in which the total of the component (1), the component (2), the component (3) and the component (5') is 90% by mass or more.
It may be added in any of the steps included in the method of producing a perovskite compound described above, may be added in the step of mixing the component (1), the component (2), the component (3) and the polymerizable compound described above, or
may be added in the step of mixing the component (1), the component (2), the component (3) and the polymer dissolved in a solvent.
From the viewpoint of enhancing the dispersibility of the perovskite compound, the component (5) is preferably added in any one of the following steps included in the method of producing a perovskite compound containing A, B, and X of (1) as components.

<<Measurement of concentration of constituent elements of perovskite compound and concentration of perovskite compound based on the measurement>>

The concentrations (μg/g) of the constituent elements of the perovskite compound contained in the composition of the present invention are measured by measuring Pb and Cs using an inductively coupled plasma mass spectrometer ICP-MS (for example, ELAN DRCII manufactured by PerkinElmer), and measuring Br using an ion chromatograph (for example, Integrion, manufactured by Thermo Fisher Scientific Inc.). The concentration of the perovskite compound is determined from the total amount of each of the constituent elements described above.
Each measurement is performed using a solution of a good solvent such as N, N-dimethylformamide and a perovskite compound.

<<Measurement of quantum yield>>

The quantum yield of the composition of the present invention is measured using an absolute PL quantum yield measuring device (for example, C9920-02, manufactured by Hamamatsu Photonics KK) at an excitation light wavelength of 450 nm at room temperature and under the atmosphere.
In the composition containing the component (1), the component (2), the component (3), and the component (4), the concentration of the perovskite compound contained in the composition is adjusted to be 2000 ppm (μg/g), 50 μL of the composition is dropped on a glass substrate having a size of 1 cm × 1 cm, and the dried one is used for measurement.
In the composition containing the component (1), the component (2), the component (3), and the component (5), the compounding ratio is adjusted such that the concentration of the perovskite compound contained in the composition becomes 2000 ppm (μg/g), and 50 μL of the composition is dropped on a glass substrate having a size of 1 cm × 1 cm , and the composition is dried and used for measurement. The same shall apply when the component (5) is replaced with the component (5').

<<Evaluation of thermal durability>>

The composition of the present invention is heated on a hot plate at 150°C for 2 minutes, the quantum yield before and after heating is measured, and the reduction rate is evaluated using the following equation.

$$\text{Reduction rate (\%)} = (1 - \text{quantum yield after heat endurance test} \div \text{quantum yield before heat endurance test}) \times 100$$

In the composition of the embodiment, in each of the above measurement methods, the reduction rate may be 54% or less, may be 50% or less, may be 45% or less, may be 43% or less. Since the effect of the composition on thermal durability is high, it is preferable that the reduction rate is lower.

<Film>

The film according to the present invention is a film using a composition containing the component (1), the component (2), the component (3), and the component (5') in which the total of the component (1), the component (2), the component (3) and the component (5') is 90% by mass or more. The composition may contain the component (6).
The shape of the film is not particularly limited, and may be any shape such as a sheet shape and a bar shape.
The thickness of the film may be from 0.01 μm to 1000 mm, from 0.1 μm to 10 mm, or from 1 μm to 1 mm.
The film may be a single layer or a multilayer. In the case of multiple layers, each layer may use the same type of composition of the embodiment or different types of composition of the embodiment.
As the film, a film formed on a substrate can be obtained, for example, by the following methods (i) to (iv) of producing a laminated structure.

<Laminated structure>

The laminated structure according to the present invention has a plurality of layers, at least one of which is the film described above.

Among the plurality of layers included in the laminated structure, the layers other than the above-described film include arbitrary layers such as a substrate, a barrier layer, a light scattering layer and the like.
The shape of the film to be laminated is not particularly limited, and may be any shape such as a sheet shape or a bar shape.

(Substrate)

The layer which the laminated structure according to the present invention may have is not particularly limited, and examples thereof include a substrate.
The substrate is not particularly limited, but may be a film, and is preferably transparent from the viewpoint of extracting emitted light. As the substrate, for example, a known material such as a polymer such as polyethylene terephthalate or glass can be used.
For example, in the laminated structure, the above-described film may be provided on a substrate.
FIG. 1 is a cross-sectional view schematically illustrating a configuration of the laminated structure according to the embodiment. In the laminated structure 1 a, the film 10 of the embodiment is provided between the substrates 20 and 21. The film 10 is sealed by a sealing material 22.

(Barrier layer)

The layer which the laminated structure according to the present invention may have is not particularly limited, and examples thereof include a barrier layer. A barrier layer may be included from the viewpoint of protecting the above-mentioned composition from water vapor of the outside air and air in the atmosphere.
The barrier layer is not particularly limited, but is preferably transparent from the viewpoint of taking out emitted light. As the barrier layer, for example, a polymer such as polyethylene terephthalate or a known barrier layer such as a glass film can be used.

(Light scattering layer)

The layer which the laminated structure according to the present invention may have is not particularly limited, and examples thereof include a light scattering layer. A light scattering layer may be included from the viewpoint of effectively using the incident light.
The light scattering layer is not particularly limited, but is preferably transparent from the viewpoint of extracting emitted light. As the light scattering layer, a known light scattering layer such as a light scattering particle such as a silica particle or an amplification diffusion film can be used.

<Light emitting device>

The light emitting device according to the present invention can be obtained by combining the composition or the laminated structure of the embodiment of the present invention with a light source. A light emitting device is a device in which light emitted from a light source is applied to a composition or a laminated structure provided at a subsequent stage to cause the composition or the laminated structure to emit light and extract light. Among the plurality of layers included in the laminated structure in the light-emitting device, layers other than the above-described film, substrate, barrier layer and light scattering layer include a light reflecting member, a luminance enhancement unit, a prism sheet, a light guide plate, and an arbitrary layer such as a medium material layer between elements.

(Light source)

The light source constituting the light emitting device according to the present invention is not particularly limited, but a light source having an emission wavelength of 600 nm or less is preferable from the viewpoint of emitting the above-described composition or semiconductor fine particles in the laminated structure. As the light source, for example, a known light source such as a light emitting diode (LED) such as a blue light emitting diode, a laser, and an EL can be used.

(Light reflecting member)

The layer which may be included in the laminated structure constituting the light emitting device according to the present invention is not particularly limited, and includes a light reflecting member. The light reflecting member may be included from the viewpoint of irradiating the light of the light source toward the composition or the laminated structure. The light reflection member is not particularly limited, but may be a reflection film.

As the reflection film, for example, a known reflection film such as a reflection mirror, a film of reflection particles, a reflection metal film or a reflector can be used.

(Luminance enhancement part)

The layer which may be included in the laminated structure constituting the light emitting device according to the present invention is not particularly limited, and examples thereof include a luminance enhancement portion. From the viewpoint of reflecting a part of the light back toward the direction in which the light was transmitted, the light emitting device may include a luminance enhancement unit.

(Prism sheet)

The layer that may be included in the laminated structure constituting the light emitting device according to the present invention is not particularly limited, and includes a prism sheet. The prism sheet typically has a base portion and a prism portion. Note that the base portion may be omitted depending on the adjacent members. The prism sheet can be attached to an adjacent member via any appropriate adhesive layer (for example, an adhesive layer or an adhesive layer). The prism sheet is configured by arranging a plurality of unit prisms that are convex on the opposite side (back side) from the viewing side. By arranging the convex portion of the prism sheet toward the rear side, light transmitted through the prism sheet is easily collected. In addition, if the convex portion of the prism sheet is arranged toward the back side, compared to the case where the convex portion is arranged toward the viewing side, less light is reflected without entering the prism sheet, and a display with high luminance can be obtained.

(Light guide plate)

The layer which may be included in the laminated structure constituting the light emitting device according to the present invention is not particularly limited, and examples thereof include a light guide plate. As the light guide plate, for example, any suitable light guide plates, such as a light guide plate having a lens pattern formed on the back side and a prism shape or the like formed on the back side and/or the viewing side so that light from the lateral direction can be deflected in the thickness direction, can be used.

(Medium material layer between elements)

The layer that may be included in the laminated structure constituting the light emitting device according to the present invention is not particularly limited, but there is a layer made of one or more medium materials (media material layer between elements) on a light path between adjacent elements (layers).

The one or more media included in the media material layer between the elements is not particularly limited, but include vacuum, air, gas, optical material, adhesive, optical adhesive, glass, polymer, solid, liquid, gel, curing material, optical coupling material, index matching or index mismatching material, refractive index gradient material, cladding or anti-cladding material, spacer, silica gel, luminance enhancement material, scattering or diffusing material, reflective or anti-reflective material, wavelength selective material, wavelength-selective anti-reflective material, color filter, or suitable media known in the art.

As a specific example of the light emitting device according to the present invention, for example, a device provided with a wavelength conversion material for an EL display or a liquid crystal display can be mentioned.

Specifically, (E1) there is a backlight (on-edge type backlight) in which the composition of the present invention is put in a glass tube or the like and sealed, and is seated between the blue light emitting diode as a light source and the light guide plate along the end surface (side surface) of the light guide plate, and converts blue light into green light or red light.

Further, (E2) there is a backlight (surface-mount type backlight) in which a film obtained by forming the composition of the present invention into a sheet, sandwiching it between two barrier films, and sealing the film was placed on the light guide plate and placed on the end surface (side surface) of the light guide plate, and converts blue light emitted from a blue light-emitting diode to the sheet through a light guide plate into green light or red light.

In addition, (E3) there is a backlight (on-chip type backlight) in which the composition of the present invention is dispersed in a resin or the like and placed near a light emitting portion of a blue light emitting diode to convert the irradiated blue light into green light or red light.

Further, (E4) there is a backlight which disperses the composition of the present invention in a resist, installs the composition on a color filter, and converts blue light emitted from a light source into green light or red light.

Further, as a specific example of the light emitting device according to the present invention, there is an illumination in which the composition of the embodiment of the present invention is molded, and is disposed after the

blue light emitting diode as a light source, and converts blue light into green light or red light, emitting white light.

<Display>

As shown in FIG. 2, the display 3 of the embodiment includes a liquid crystal panel 40 and the above-described light emitting device 2 in this order from the viewing side. The light emitting device 2 includes a laminated structure 1b and a light source 30. The laminated structure 1b is such that the above-described laminated structure 1a further includes a prism sheet 50 and a light guide plate 60. The display may further comprise any suitable other components.

(LCD panel)

The liquid crystal panel typically includes a liquid crystal cell, a viewing-side polarizing plate disposed on the viewing side of the liquid crystal cell, and a back-side polarizing plate disposed on the back side of the liquid crystal cell. The viewing side polarizing plate and the back side polarizing plate can be arranged such that their absorption axes are substantially orthogonal or parallel.

(Liquid crystal cell)

A liquid crystal cell has a pair of substrates and a liquid crystal layer as a display medium sandwiched between the substrates. In a general configuration, a color filter and a black matrix are provided on one substrate, and a switching element for controlling electro-optical characteristics of liquid crystal is provided on the other substrate, and a scanning line for providing a gate signal to the switching element, and a signal line for supplying a source signal, and a pixel electrode and a counter electrode, are disposed. The distance (cell gap) between the substrates can be controlled by a spacer or the like. On the side of the substrate in contact with the liquid crystal layer, for example, an alignment film made of polyimide or the like can be provided.

(Polarizer)

The polarizing plate typically has a polarizer and protective layers disposed on both sides of the polarizer. The polarizer is typically an absorption polarizer.

As the polarizer, any appropriate polarizer is used. For example, there are materials obtained by adsorbing dichroic substances such as iodine and dichroic dyes onto hydrophilic polymer films such as polyvinyl alcohol film, partially formalized polyvinyl alcohol film, ethylene/vinyl acetate copolymer partially saponified film and uniaxially stretching, and polyene oriented film such as dehydrated polyvinyl alcohol and dechlorinated polyvinyl chloride, and the like. Among these, a polarizer obtained by adsorbing a dichroic substance such as iodine on a polyvinyl alcohol-based film and uniaxially stretching is particularly preferable because of its high polarization dichroic ratio.

Applications of the composition of the present invention include, for example, wavelength conversion materials for light emitting diodes (LEDs).

<LED>

The composition of the present invention can be used, for example, as a material for a light emitting layer of an LED.

An LED containing the composition of the present invention, for example, has a structure in which the composition of the present invention and conductive particles such as ZnS are mixed and laminated in a film form, the n-type transport layer is laminated on one side, and the p-type transport layer is laminated on the other side, wherein when a current is passed, holes of the p-type semiconductor and electrons of the n-type semiconductor cancel out the charge in the particles of the component (1) and the component (2) contained in the composition of the junction surface, thus emitting light.

<Solar battery>

The composition of the present invention can be used as an electron transporting material contained in an active layer of a solar battery.

In the solar battery, though configuration is not particularly limited, for example, fluorine-doped tin oxide (FTO) substrate, a titanium oxide dense layer, a porous aluminum oxide layer, an active layer containing the composition of the present invention, a hole transporting layer such as 2,2',7,7'-tetrakis (N,N-dip-methoxyphenylamine) -9,9-spirobifluorene (Spiro-MeOTAD) and a silver (Ag) electrode are disposed in this order.

The dense layer of titanium oxide has a function of transporting electrons, an effect of suppressing roughness of FTO, and a function of suppressing reverse electron transfer.

The porous aluminum oxide layer has a function of improving light absorption efficiency.

The composition of the present invention contained in the active layer has functions of charge separation and electron transport.

<Production method of laminated structure>

Examples of the production method of the laminated structure include the following production methods (i), (ii), (iii), and (iv).

Production method (i): a production method of a laminated structure containing a step of mixing the component (1), the component (2), the component (3), and the component (4),
a step of coating the resultant mixture on a substrate, and
a step of removing the solvent.

Production method (ii): a production method of a laminated structure containing a step of mixing the component (1), the component (2), the component (3), and a polymer dissolved in a solvent;
a step of coating the resultant mixture on a substrate, and
a step of removing the solvent.

Production method (iii): a production method of a laminated structure containing a step of laminating a composition containing the component (1), the component (2), the component (3), and the component (5') in which the total of the component (1), the component (2), the component (3), and the component (5') is 90% by mass or more to a substrate.

Production method (iv): a production method containing a step of mixing the component (1), the component (2), the component (3), and a polymerizable compound;
a step of coating the resultant mixture on a substrate, and
a step of polymerizing the polymerizable compound.

The step of mixing and the step of removing a solvent, which are included in the production method (i) above,
the step of mixing and the step of removing a solvent, which are included in the production method (ii) above, and
the step of mixing and the step of polymerizing a polymerizable compound, which are included in the production method (iv) above
can be the same steps included in the production method of a composition containing the component (2), the component (3) and the component (5') in which the total of the component (2), the component (3) and the component (5') is 90% by mass or more already explained, respectively.

The step of coating on a substrate, which is included in the production methods (i), (ii) and (iv), is not particularly limited, and known applying and coating methods such as gravure coating, bar coating, printing, spraying, spin coating, dipping method, die coating and the like can be used.

In the step of laminating to a substrate included in the production method (iii), an arbitrary adhesive can be used.

The adhesive is not particularly limited as long as it does not dissolve the compounds of the components (1), (2) and (3), and a known adhesive can be used.

The method of producing a laminated structure may further include a step of laminating an arbitrary film to the laminated structure obtained in (i) to (iv).

As an arbitrary film to be laminated, for example, a reflection film and a diffusion film can be mentioned.

In the step of laminating a film, an arbitrary adhesive can be used.

The above-mentioned adhesive is not particularly limited as long as it does not dissolve the compounds of the components (1), (2) and (3), and known adhesives can be used.

<Method of producing light emitting device>

For example, a production method including the above-described light source and a step of installing the above-described composition or the laminated structure on an optical path subsequent to the light source is exemplified.

EXAMPLES

Hereinafter, the present invention will be described more specifically based on Examples and Comparative Examples, but the present invention is not limited to the following Examples.

(Concentration measurement of perovskite compound)

The concentration of the perovskite compound in the compositions obtained in Examples 1 to 3 and Comparative

Examples 1 to 3 was measured by the following method.

First, N,N-dimethylformamide was added to a dispersion containing a perovskite compound and a solvent obtained by redispersion to dissolve the perovskite compound.

Thereafter, the measurement was performed using ICP-MS (manufactured by PerkinElmer, ELAN DRCII) and ion chromatograph (manufactured by Thermo Fisher Scientific, Inc., Integrion).

(Measurement of quantum yield)

The quantum yields of the compositions obtained in Examples 1 to 3 and Comparative Examples 1 to 3 were measured by using an absolute PL quantum yield measurement device (C9920-02, manufactured by Hamamatsu Photonics KK) with an excitation light of 450 nm at room temperature in the atmosphere.

(Evaluation of thermal durability)

The compositions obtained in Examples 1 to 3 and Comparative Examples 1 to 3 were heated on a hot plate at 150°C for 2 minutes, and the quantum yields before and after heating were measured. The smaller the reduction rate thus obtained, the higher the thermal durability.

$$\text{Reduction rate (\%)} = (1 - \text{quantum yield after heat endurance test} \div \text{quantum yield before heat endurance test}) \times 100$$

(Observation of perovskite compound by transmission electron microscope)

The perovskite compound was observed using a transmission electron microscope (JEM-2200FS, manufactured by JEOL Ltd.). As a sample for observation, a perovskite compound was collected from a dispersion composition containing a perovskite compound on a grid with a support film, and then observed at an acceleration voltage of 200 kV.

The average Feret diameter was the average value of the Feret diameters of 20 perovskite compounds.

[Example 1]

0.814 g of cesium carbonate, 40 mL of 1-octadecene solvent, and 2.5 mL of oleic acid were mixed. The mixture was stirred with a magnetic stirrer and heated at 150°C for 1 hour while flowing nitrogen to prepare a cesium carbonate solution 1.

0.276 g of lead bromide ($PbBr_2$) was mixed with 20 mL of 1-octadecene solvent. After heating at a temperature of 120°C for 1 hour while stirring with a magnetic stirrer and flowing nitrogen, 2 mL of oleic acid and 2 mL of oleylamine were added to prepare a lead bromide dispersion.

After the temperature of the lead bromide dispersion was raised to 160°C, 1.6 mL of the above-mentioned cesium carbonate solution was added. After the addition, the temperature of the reaction vessel was lowered to room temperature by immersing the reaction vessel in ice water to obtain a dispersion.

Next, the dispersion was centrifuged at 10,000 rpm for 5 minutes to separate the precipitate, thereby obtaining a perovskite compound as the precipitate. After dispersing the perovskite compound in 5 mL of toluene, 500 μL of the dispersion was collected and redispersed in 4.5 mL of toluene to obtain a dispersion 1 containing the perovskite compound and a solvent.

The concentration of the perovskite compound measured by ICP-MS and ion chromatography was 2000 ppm (μg/g).

When the X-ray diffraction pattern of the compound collected by allowing the solvent to dry naturally was measured by an X-ray diffractometer (XRD, Cu Kα ray, X'pert PRO MPD, manufactured by Spectris), a peak derived from (hkl) = (001) was observed at $2\theta = 14°$, confirming that it has a three-dimensional perovskite type crystal structure.

The average ferret diameter of the perovskite compound observed by TEM was 11 nm.

After dilution with toluene so that the concentration of the perovskite compound became 200 ppm (μg/g), the quantum yield measured by a quantum yield measuring device was 30%.

Tributyl-n-octylphosphonium bromide was mixed with the dispersion 1 containing the above-described perovskite compound and solvent. In the dispersion, the molar ratio of the element P contained in tributyl-n-octylphosphonium bromide to the element Pb contained in the perovskite compound was tributyl-n-octylphosphonium bromide/Pb = 0.85.

Next, tetramethoxysilane was mixed with the above dispersion. In the dispersion, the molar ratio of the Si element contained in the tetramethoxysilane to the Pb element contained in the perovskite compound was Si/Pb = 45.

The above-mentioned dispersion was subjected to a modification treatment for 1 day under stirring with a stirrer at 25°C and 80% humidity.

50 μL of the above dispersion was cast on a glass substrate having a size of 1 cm × 1 cm and dried naturally to obtain a composition.

The above composition was heated on a hot plate heated to 150°C for 2 minutes to perform a thermal durability test. When the reduction rate was calculated by measuring the quantum yield before and after the durability test, the reduction rate was 49%.

[Example 2]

A dispersion containing a perovskite compound and a solvent was obtained in the same manner as in Example 1. After dilution with toluene so that the concentration of the perovskite compound became 200 ppm (μg/g), the quantum yield measured by a quantum yield measuring device was 30%.

Trioleyl phosphite was mixed with the dispersion 1 containing the above-described perovskite compound and solvent. In the dispersion, the molar ratio of the element P contained in trioleyl phosphite to the element Pb contained in the perovskite compound was trioleyl phosphite/Pb = 2.1. Next, tetramethoxysilane was mixed with the above dispersion. In the dispersion, the molar ratio of the Si element contained in the tetramethoxysilane to the Pb element contained in the perovskite compound was Si/Pb = 45.

The above-mentioned dispersion was subjected to a modification treatment for 1 day under stirring with a stirrer at 25°C and 80% humidity.

50 μL of the above dispersion was cast on a glass substrate having a size of 1 cm × 1 cm and dried naturally to obtain a composition. The above composition was heated on a hot plate heated to 150°C for 2 minutes to perform a thermal durability test. When the reduction rate was calculated by measuring the quantum yield before and after the durability test, the reduction rate was 44%.

[Example 3]

A dispersion 1 containing a perovskite compound and a solvent was obtained in the same manner as in Example 1. After dilution with toluene so that the concentration of the perovskite compound became 200 ppm (μg/g), the quantum yield measured by a quantum yield measuring device was 30%.

Sodium dodecyl sulfate was mixed with the dispersion 1 containing the above-described perovskite compound and solvent. In the dispersion, the molar ratio of the element P contained in sodium dodecyl sulfate to the element Pb contained in the perovskite compound was sodium dodecyl sulfate/Pb = 12. Next, tetramethoxysilane was mixed with the above dispersion. In the dispersion, the molar ratio of the Si element contained in the tetramethoxysilane to the Pb element contained in the perovskite compound was Si/Pb = 45.

The above-mentioned dispersion was subjected to a modification treatment for 1 day under stirring with a stirrer at 25°C and 80% humidity.

50 μL of the above dispersion was cast on a glass substrate having a size of 1 cm × 1 cm and dried naturally to obtain a composition. The above composition was heated on a hot plate heated to 150°C for 2 minutes to perform a thermal durability test. When the reduction rate was calculated by measuring the quantum yield before and after the durability test, the reduction rate was 41%.

[Comparative Example 1]

A dispersion 1 containing a perovskite compound and a solvent was obtained in the same manner as in Example 1. After dilution with toluene so that the concentration of the perovskite compound became 200 ppm (μg/g), the quantum yield measured by a quantum yield measuring device was 30%.

A composition was obtained by casting 50 μL of the dispersion 1 containing the above-described perovskite compound and the solvent on a glass substrate having a size of 1 cm × 1 cm and naturally drying. The above composition was heated on a hot plate heated to 150°C for 2 minutes to perform a thermal durability test. When the reduction rate was calculated by measuring the quantum yield before and after the durability test, the reduction rate was 57%.

[Comparative Example 2]

A dispersion 1 containing a perovskite compound and a solvent was obtained in the same manner as in Example 1. After dilution with toluene so that the concentration of the perovskite compound became 200 ppm (μg/g), the quantum

yield measured by a quantum yield measuring device was 30%.

Tributyl-n-octylphosphonium bromide was mixed with the dispersion 1 containing the above-described perovskite compound and the solvent. In the dispersion, the molar ratio of the element P contained in tributyl-n-octylphosphonium bromide to the element Pb contained in the perovskite compound was tributyl-n-octylphosphonium bromide/Pb = 0.85.

50 μL of the above dispersion was cast on a glass substrate having a size of 1 cm × 1 cm and dried naturally to obtain a composition. The above composition was heated on a hot plate heated to 150°C for 2 minutes to perform a thermal durability test. When the reduction rate was calculated by measuring the quantum yield before and after the durability test, the reduction rate was 68%.

[Comparative Example 3]

A dispersion 1 containing a perovskite compound and a solvent was obtained in the same manner as in Example 1. After dilution with toluene so that the concentration of the perovskite compound became 200 ppm (μg/g), the quantum yield measured by a quantum yield measuring device was 30%.

Next, tetramethoxysilane was mixed with the dispersion 1 containing the above-mentioned perovskite compound and the solvent. In the dispersion, the molar ratio of the Si element contained in the tetramethoxysilane to the Pb element contained in the perovskite compound was Si/Pb = 45.

The above-mentioned dispersion was subjected to a modification treatment for 1 day under stirring with a stirrer at 25°C and 80% humidity.

50 μL of the above dispersion was cast on a glass substrate having a size of 1 cm × 1 cm and dried naturally to obtain a composition. The above composition was heated on a hot plate heated to 150°C for 2 minutes to perform a thermal durability test. When the reduction rate was calculated by measuring the quantum yield before and after the durability test, the reduction rate was 59%.

From the above results, the compositions according to Examples 1 to 3 of the present invention exhibited higher thermal durability than the compositions according to Comparative Examples 1 to 3.

[Reference Example 1]

After removing the solvent as necessary, the composition described in Examples 1 to 3 was mixed with a resin as necessary, and the mixture was placed in a glass tube or the like and sealed, then, this was placed between a blue light emitting diode as a light source and a light guide plate, to fabricate a backlight capable of converting blue light of the blue light emitting diode into green light or red light.

[Reference Example 2]

After removing the solvent as necessary, the composition described in Examples 1 to 3 was mixed with a resin as necessary, and the mixture was sheeted to obtain a resin composition, and this was sandwiched with two barrier films to obtain a sealed film which was then placed on the light guide plate, to fabricate a backlight capable of converting the blue light emitted from the blue light-emitting diode placed on the end surface (side surface) of the light guide plate to the sheet through the light guide plate into green light or red light.

[Reference Example 3]

After removing the solvent as necessary, the composition described in Examples 1 to 3 was mixed with a resin as necessary, and this is placed near the light emitting portion of the blue light emitting diode, to fabricate a backlight capable of converting irradiating blue light to green light or red light.

[Reference Example 4]

After removing the solvent as necessary, the composition described in Examples 1 to 3 was mixed with a resin as necessary, then, a wavelength conversion material can be obtained by removing the solvent. The resultant wavelength conversion material is placed between a blue light emitting diode as a light source and a light guide plate, or at a stage subsequent to OLED as a light source, to fabricate a backlight capable of converting blue light of the light source to green light or red light.

[Reference Example 5]

The composition described in Examples 1 to 3 is mixed with conductive particles such as ZnS to form a film, and an n- type transport layer is laminated on one side, and a p-type transport layer is laminated on the other side, to obtain and LED. When a current is passed, holes in the p-type semiconductor and electrons in the n-type semiconductor cancel out the charges in the perovskite compound on the junction surface, so that light can be emitted.

[Reference Example 6]

A dense titanium oxide layer is laminated on the surface of a fluorine-doped tin oxide (FTO) substrate, a porous aluminum oxide layer is laminated thereon, and the composition described in Examples 1 to 3 is laminated thereon, and the solvent is removed, then, a hole transporting layer such as 2,2-, 7,7-tetrakis-(N,N-di-p-methoxyphenylamine) 9,9-spirobifluorene (Spiro-OMeTAD) is laminated thereon, and then, a silver (Ag) layer is laminated thereon, to produce a solar battery.

[Reference Example 7]

After mixing the composition described in Examples 1 to 3 with a resin, a solvent is removed and the mixture is molded to obtain a resin composition containing the composition of the present invention. By placing this at a stage subsequent to a blue light emitting diode, a laser diode illumination is fabricated that converts blue light irradiated from the blue light emitting diode to the above-described resin molded article to green light or red light, thereby emitting white light.

Industrial applicability

According to the present invention, a composition containing a perovskite compound having high thermal durability can be obtained. Furthermore, the composition can be used to provide a film, a laminated structure, and a display.

Explanation of symbols

| | |
|---|---|
| 1a, 1b: | laminated structure, |
| 10: | film, |
| 20, 21: | substrate, |
| 22: | sealing material, |
| 2: | light emitting device, |
| 3: | display, |
| 30: | light source, |
| 40: | liquid crystal panel, |
| 50: | prism sheet, |
| 60: | light guide plate |

## Claims

**1.** A composition comprising a component (1), a component (2), and a component (3) described below:

(A indicates a component positioned at each vertex of a hexahedron having B at the center in a perovskite type crystal structure and is a monovalent cation.
B indicates a component positioned at the centers of the hexahedron where A is disposed at each vertex and the octahedron where X is disposed at each vertex in the perovskite type crystal structure and is a metal ion.
X indicates a component positioned at each vertex of an octahedron having B at the center in the perovskite type crystal structure and is at least one ion selected from the group consisting of a halide ion and a thiocyanate ion.)

Component (2): a compound represented by the formula (C) or a modified product thereof

Component (3): at least one compound selected from the group consisting of compounds represented by the formulae (X1) to (X3) and salts thereof

[Chemical Formula 1]

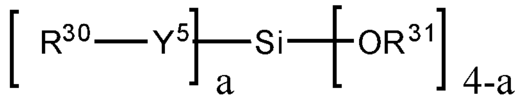

(C)

(In the formula (C), $Y^5$ represents a single bond, an oxygen atom or a sulfur atom.
When Y is an oxygen atom, $R^{30}$ and $R^{31}$ each independently represent a hydrogen atom, an alkyl group having 1 to 20 carbon atoms, a cycloalkyl group having 3 to 30 carbon atoms, or an unsaturated hydrocarbon group having 2 to 20 carbon atoms.
When $Y^5$ is a single bond or a sulfur atom, $R^{30}$ represents an alkyl group having 1 to 20 carbon atoms, a cycloalkyl group having 3 to 30 carbon atoms, or an unsaturated hydrocarbon group having 2 to 20 carbon atoms, and $R^{31}$ represents a hydrogen atom, an alkyl group having 1 to 20 carbon atoms, a cycloalkyl group having 3 to 30 carbon atoms, or an unsaturated hydrocarbon group having 2 to 20 carbon atoms.
Each hydrogen atom contained in the group represented by $R^{30}$ or $R^{31}$ may be independently substituted with a halogen atom.
a is an integer of 1 to 3.
When a is 2 or 3, a plurality of $Y^5$ may be the same or different.
When a is 2 or 3, a plurality of $R^{30}$ may be the same or different.
When a is 1 or 2, a plurality of $R^{31}$ may be the same or different.)

[Chemical Formula 2]

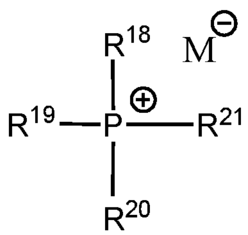

(X1)

[Chemical Formula 3]

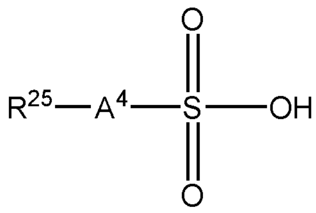

(X2)

[Chemical Formula 4]

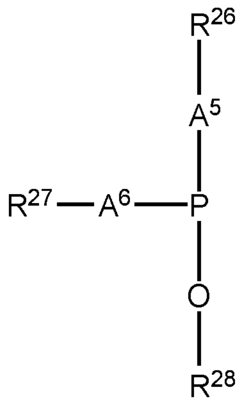

(X3)

(In the formula (X1), $R^{18}$ to $R^{21}$ each independently represent an alkyl group having 1 to 20 carbon atoms, a cycloalkyl group having 3 to 30 carbon atoms, or an aryl group having 6 to 30 carbon atoms, and they optionally have a substituent. $M^-$ represents a counter anion.
In formula (X2), $A^4$ represents a single bond or an oxygen atom. $R^{25}$ represents an alkyl group having 1 to 12 carbon atoms, a cycloalkyl group having 3 to 30 carbon atoms, or an aryl group having 6 to 30 carbon atoms, and they optionally have a substituent.
In formula (X3), $A^5$ and $A^6$ each independently represent a single bond or an oxygen atom. $R^{26}$ to $R^{28}$ each independently represent an alkyl group having 1 to 20 carbon atoms, a cycloalkyl group having 3 to 30 carbon atoms, an aryl group having 6 to 30 carbon atoms, an alkenyl group having 2 to 20 carbon atoms, or an alkynyl group having 2 to 20 carbon atoms, and they optionally have a substituent.
The hydrogen atoms contained in the groups represented by $R^{18}$ to $R^{21}$ and $R^{25}$ to $R^{28}$ may be independently substituted with a halogen atom.).

**2.** A film using the composition according to Claim 1.

**3.** A laminated structure comprising the film according to Claim 2.

**4.** A light emitting device comprising the laminated structure according to Claim 3.

**5.** A display comprising the laminated structure according to Claim 3.

[Fig. 1]

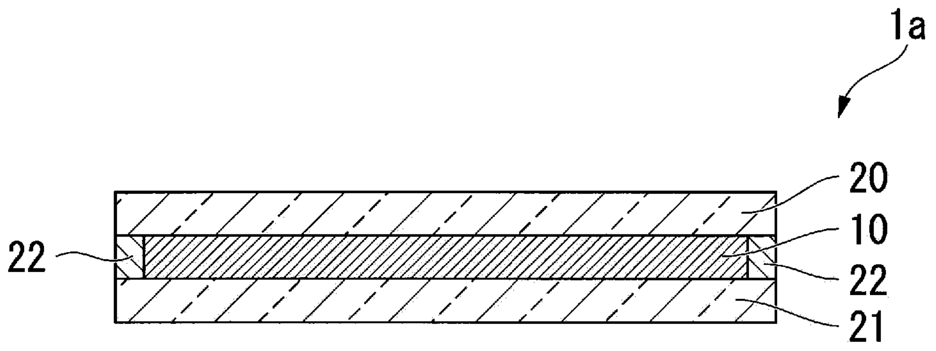


Fig. 1

[Fig. 2]

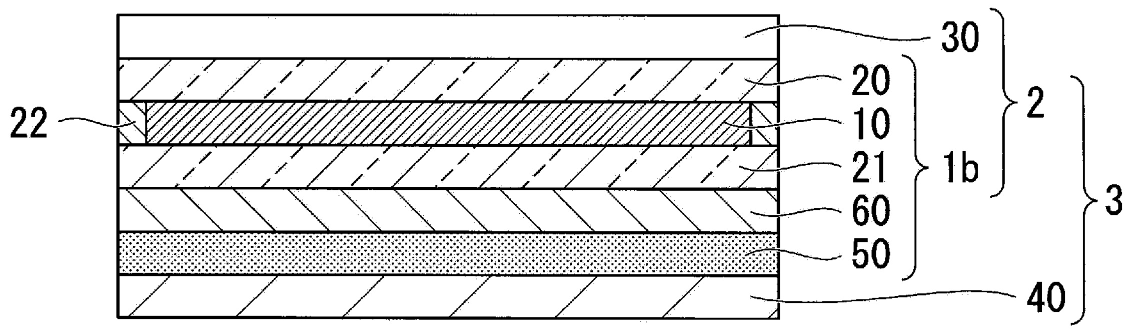


Fig. 2

**INTERNATIONAL SEARCH REPORT**

International application No.
PCT/JP2018/047003

A. CLASSIFICATION OF SUBJECT MATTER
Int.Cl. C09K11/66(2006.01)i, H01L33/50(2010.01)i

According to International Patent Classification (IPC) or to both national classification and IPC

B. FIELDS SEARCHED

Minimum documentation searched (classification system followed by classification symbols)
Int.Cl. C09K11/66, H01L33/50

Documentation searched other than minimum documentation to the extent that such documents are included in the fields searched

| | |
|---|---|
| Published examined utility model applications of Japan | 1922-1996 |
| Published unexamined utility model applications of Japan | 1971-2019 |
| Registered utility model specifications of Japan | 1996-2019 |
| Published registered utility model applications of Japan | 1994-2019 |

Electronic data base consulted during the international search (name of data base and, where practicable, search terms used)
CAplus/REGISTRY(STN)

C. DOCUMENTS CONSIDERED TO BE RELEVANT

| Category* | Citation of document, with indication, where appropriate, of the relevant passages | Relevant to claim No. |
|---|---|---|
| A | WO 2017/221833 A1 (SUMITOMO CHEMICAL CO., LTD.) 28 December 2017, entire text & TW 201819301 A | 1-5 |
| A | JP 2017-142486 A (LEXTAR ELECTRONICS CORP.) 17 August 2017, entire text & JP 2017-108129 A & US 2017/0153382 A1 & US 2017/0155020 A1 & US 2017/0153382 A1 & EP 3192846 A1 & DE 102016223645 A & CN 106816520 A & CN 107017325 A & KR 10-2017-0063417 A & KR 10-2017-0066257 A & TW 201720909 A & TW 201718825 A | 1-5 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 28.01.2019 | 12.02.2019 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

INTERNATIONAL SEARCH REPORT

International application No.
PCT/JP2018/047003

C (Continuation). DOCUMENTS CONSIDERED TO BE RELEVANT

| Category* | Citation of document, with indication, where appropriate, of the relevant passages | Relevant to claim No. |
|---|---|---|
| A | WO 2016/151933 A1 (KONICA MINOLTA, INC.) 29 September 2016, entire text (Family: none) | 1-5 |
| P, A | WO 2018/117130 A1 (SUMITOMO CHEMICAL CO., LTD.) 28 June 2018, entire text (Family: none) | 1-5 |
| P, A | WO 2018/117131 A1 (SUMITOMO CHEMICAL CO., LTD.) 28 June 2018, entire text (Family: none) | 1-5 |
| E, A | WO 2018/235945 A1 (SUMITOMO CHEMICAL CO., LTD.) 27 December 2018, entire text (Family: none) | 1-5 |
| E, X | WO 2018/235948 A1 (SUMITOMO CHEMICAL CO., LTD.) 27 December 2018, entire text (Family: none) | 1-5 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- **L. PROTESESCU ; S. YAKUNIN ; M.I. BODNARCHUK ; F. KRIEG ; R. CAPUTO ; C.H. HENDON ; R.X. YANG ; A. WALSH ; M.V. KOVALENKO.** *Nano Letters,* 2015, vol. 15, 3692-3696
- **PP BOIX et al.** *J. Phys. Chem. Lett.,* 2015, vol. 6, 898-907
- *Nano Lett.,* 2015, vol. 15, 3692-3696
- *ACSNano,* 2015, vol. 9, 4533-4542